(19) Europäisches Patentamt
European Patent Office
Office européen des brevets

(11) **EP 2 958 231 A1**

(12) **EUROPEAN PATENT APPLICATION**

(43) Date of publication:
**23.12.2015 Bulletin 2015/52**

(51) Int Cl.:
**H03B 5/36** *(2006.01)*    **G01R 31/28** *(2006.01)*

(21) Application number: **15172057.0**

(22) Date of filing: **15.06.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **16.06.2014   JP 2014123581**

(71) Applicant: **Renesas Electronics Corporation Kanagawa 211-8668 (JP)**

(72) Inventors:
• **OZAWA, Osamu
  Kawasaki-shi, Kanagawa 211-8668 (JP)**

• **NISHIOKA, Soshiro
  Kawasaki-shi, Kanagawa 211-8668 (JP)**
• **NAKAMURA, Takashi
  Kawasaki-shi, Kanagawa 211-8668 (JP)**
• **ABE, Susumu
  Kawasaki-shi, Kanagawa 211-8668 (JP)**
• **TANIGUCHI, Kazuya
  Kawasaki-shi, Kanagawa 211-8668 (JP)**
• **TANIMURA, Masaaki
  Kawasaki-shi, Kanagawa 211-8668 (JP)**

(74) Representative: **Glawe, Delfs, Moll Partnerschaft mbB von Patent- und Rechtsanwälten Postfach 26 01 62 80058 München (DE)**

(54) **SEMICONDUCTOR INTEGRATED CIRCUIT DEVICE WITH CRYSTAL RESONATOR AND MANUFACTURING METHOD OF ELECTRONIC DEVICE USING THE SAME**

(57)    A semiconductor integrated circuit device having a function to perform oscillation in combination with a crystal oscillator, includes: a first impedance element including a first external terminal coupled to one terminal of the crystal oscillator, a second external terminal coupled to the other terminal of the crystal oscillator, and first and second terminals coupled to the first and second external terminals when the oscillation is performed; a first variable capacitance circuit coupled to the first terminal of the feedback impedance element, and a configuration circuit for setting a capacitance value of the first variable capacitance circuit. A measurement signal is supplied to the second terminal of the feedback impedance element, and in response to this, the capacitance value of the first variable capacitance circuit is set by the configuration circuit based on the delay time of an observation signal generated at the first terminal with respect to the measurement signal.

*FIG. 7*

**Description**

CROSS-REFERENCE TO RELATED APPLICATIONS

The disclosure of Japanese Patent Application No. 2014-123581 filed on June 16, 2014 including the specification, drawings and abstract is incorporated herein by reference in its entirety.

BACKGROUND

The present invention relates to a semiconductor integrated circuit device and a manufacturing method of an electronic device using the same. More particularly, the present invention relates to a semiconductor integrated circuit device having a function to perform oscillation in combination with a crystal oscillator, and to a manufacturing method of an electronic device including the crystal oscillator mounted in an electronic substrate (hereinafter, also referred to as a substrate) as well as the semiconductor integrated circuit device.

For example, techniques for performing oscillation using a crystal oscillator are described in Patent Documents 1 and 2 (Japanese Patent Application Laid-Open No. 2000-134036 and No. 2003-283249). Patent Document 1 describes a method for forming a variable capacitance element for frequency adjustment in a semiconductor integrated circuit device to adjust the oscillation frequency when performing oscillation by using a crystal oscillator. Further, Patent Document 2 describes a method for providing a crystal oscillator outside a semiconductor integrated circuit device, as well as a plurality of capacitances inside the semiconductor integrated circuit device to configure an oscillator circuit with the crystal oscillator and the capacitance elements.

SUMMARY

An electronic device includes a substrate, a crystal oscillator mounted in the substrate, one or a plurality of semiconductor integrated circuit devices and passive elements (resistive elements and/or capacitance elements) mounted in the substrate. The electronic device achieves a predetermined function by these components mounted in the substrate. In this case, clock signals and the like are formed in order to operate the electronic device by using the crystal oscillator and using the semiconductor integrated circuit device.

In order to oscillate a clock signal of a desired frequency by using the crystal oscillator, it is required that a capacitance element or the like having an appropriate capacitance value is coupled to the crystal oscillator and the semiconductor integrated circuit device through a wiring pattern over the substrate. When the capacitance element, and the like, is mounted in the substrate, the number of mounting parts increases and thus the cost will increase. Further, the area for mounting the capacitance element, and the like, is required in the substrate, leading to an increase in the size of the substrate. In addition, a terminal of the capacitance element, and the like, may be removed from the wiring pattern of the substrate. As a result, the reliability will be reduced.

Meanwhile, the substrate or the wiring pattern over the substrate has parasitic resistance and parasitic capacitance. Thus, in order to oscillate a clock signal of a desired frequency, it is required to set the value of the capacitance element and the like coupled to the crystal oscillator, by also taking into account the parasitic resistance and the parasitic capacitance. In order to allow the oscillation of the clock signal of desired frequency by taking into account the parasitic resistance and parasitic capacitance, for example, the manufacturer of an electronic device (hereinafter referred to as the electronic device manufacture) provides a substrate in which a wiring patter is formed to the manufacturer of a crystal oscillator (hereinafter referred to as the crystal oscillator manufacturer), and the appropriate capacitance value and the like is obtained in the crystal oscillator manufacturer. In this case, work occurs in the crystal oscillator manufacturer, resulting in a delay in the production of the electronic device. Further, when the electronic device manufacturer changes the substrate and/or the wiring pattern over the substrate, the parasitic resistance and the parasitic capacitance change as well. Thus, each time the substrate and/or the wiring pattern over the substrate is changed, it is required to also change the value of the capacitance, and the like, which is coupled to the crystal oscillator and to the semiconductor integrated circuit device. In other words, there is a concern that work may occur in the crystal oscillator manufacturer each time the substrate and/or the wiring pattern over the substrate is changed, resulting in further delay in the production of the electronic device.

As described in Patent Documents 1 and 2, for example, by placing a capacitance element inside of the semiconductor integrated circuit device, it is possible to reduce the number of capacitance elements mounted in the substrate. As a result, it is possible to reduce the increase in the cost and the increase in the mounting area. Further, it is possible to reduce the number of connections between the wiring pattern over the substrate and the terminals of the capacitance element and the like, which can also prevent the reduction of the reliability.

Further, there may be a case in which a variable capacitance circuit is used as the capacitance element placed inside the semiconductor integrated circuit device, and the capacitance value of the variable capacitance circuit is set from the outside of the semiconductor integrated circuit device. In this way, it is possible to oscillate a clock signal of a desired frequency by changing the capacitance value from outside the semiconductor integrated circuit. However, also in such a case, the crystal oscillator manufacturer should obtain the appropriate capacitance value and the like. In this case, it is necessary for the crystal oscillator manufacturer to obtain the appropriate capacitance value by changing the capacitance value of the variable capacitance circuit from outside the semiconductor integrated circuit device. From the point of view of the crystal oscillator manufacturer, it is necessary to work with an unfamiliar semiconductor integrated circuit device, so that the work of obtaining the appropriate capacitance value may be a considerable burden. As a result, the time required for the work in the crystal oscillator manufacturer may increase and the production of the electronic device may further be delayed.

Both Patent Documents 1 and 2 are not aware of the work imposed on the crystal oscillator manufacturer, namely, the work of obtaining the capacitance value and the like in order to obtain a desired frequency. Further, they are not also aware of the delay that occurs due to the process through the crystal oscillator manufacturer.

These and other objects and advantages will become apparent from the following description of the present specification and the accompanying drawings.

A typical one of the aspects of the invention disclosed in this application will be briefly described as follows.

That is, there is provided a semiconductor integrated circuit device having a function to perform oscillation in combination with a crystal oscillator. The semiconductor integrated circuit device includes a first external terminal to which one terminal of the crystal oscillator is coupled, and a second external terminal to which the other terminal of the crystal oscillator is coupled. Here, the semiconductor integrated circuit device includes: a feedback impedance element having a first terminal coupled to the first external terminal, and a second terminal coupled to the second external terminal when the oscillation is performed; a first variable capacitance circuit coupled to the first terminal of the feedback impedance element; and a configuration circuit for setting a capacitance value of the first variable capacitance circuit. The semiconductor integrated circuit device supplies a first measurement signal to the second terminal of the feedback impedance element. In response to the supply of the first measurement signal, the capacitance value of the first variable capacitance circuit is set by the configuration circuit, based on the delay time for the first measurement signal which is a first observation signal generated at the first terminal of the feedback impedance element.

A delay circuit can be considered being configured by the feedback impedance element, the first variable capacitance circuit, and a parasitic capacitance associated with the first external terminal. When the first measurement signal is supplied as the input signal of the delay circuit, a signal having a delay time is generated as the first observation signal. Here, the delay time is determined by the impedance value of the feedback impedance element configuring the delay circuit, and by the capacitance value of the capacitance circuit (including the first variable capacitance circuit and the parasitic capacitance associated with the first external terminal).

In this case, the delay time varies according to the value of the first variable capacitance circuit coupled to the feedback impedance element and according to the value of the parasitic capacitance associated with the first external terminal, so that the delay time can be considered changing depending on the value of the parasitic capacitance. Thus, the capacitance value of the first variable capacitance circuit can be set taking into account the value of the parasitic capacitance associated with the first external terminal, by setting the capacitance value of the first variable capacitance circuit based on the delay time.

For example, the delay time when the clock signal of desired frequency is oscillated is obtained and presented in advance. Then, in the electronic device manufacturer, the capacitance value of the first variable capacitance circuit is sets by the configuration circuit so as to match the presented delay time. This allows the electronic device manufacturer to set the appropriate capacitance value to the semiconductor integrated circuit device by itself. In other words, there is no need to provide the substrate to the crystal oscillator manufacturer to obtain the appropriate capacitance value in the crystal oscillator manufacturer. As a result, it is possible to reduce the delay in the production.

In an embodiment from the point of view of the semiconductor integrated circuit device, the feedback impedance element is a feedback resistive element. A measurement circuit is placed in the semiconductor integrated circuit device to measure the time difference between the change in a first signal at the first terminal of the feedback resistive element, and the change in a second signal at the second terminal of the feedback resistive element. Here, the time difference corresponds to the delay time. It is possible to obtain the delay time by measuring the first signal at the first terminal and the second signal at the second terminal, and to facilitate the measurement.

Further, in an embodiment from the point of view of a manufacturing method of an electronic device, there is provided a manufacturing method of an electronic device including a crystal oscillator combined with a wiring pattern formed in a substrate, and a semiconductor integrated circuit device having a first external terminal and a second external terminal that are combined with the wiring pattern. Here, the semiconductor integrated circuit device includes: a feedback impedance element having a first terminal coupled to the first external terminal as well as a second terminal coupled to the second external terminal when oscillation is performed by use of the crystal oscillator; a first variable capacitance circuit coupled to the first terminal of the feedback impedance element; and a configuration circuit for setting a capacitance value of the first variable capacitance circuit. The semiconductor integrated circuit device supplies a first measurement signal to the second terminal of the feedback impedance element. Then, in response to the supply of the first measurement signal, the capacitance value of the first variable capacitance circuit is set by the configuration circuit so that the delay time of the signal generated at the first terminal of the feedback impedance element becomes a predetermined value.

The first external terminal is coupled to the wiring pattern formed in the substrate. Thus, a parasitic capacitance is associated with the first external terminal. The capacitance value of the first variable capacitance circuit is determined so as to be able to oscillate a clock signal of a desired frequency when the parasitic capacitance is associated with the first external terminal. Then, the delay time at this time is provided as a predetermined value. In the manufacturing method of the electronic device, the capacitance value of the first variable capacitance is set by the configuration circuit so as to match the predetermined value provided as described above. In this way, it is possible to produce the electronic device capable of oscillating the clock signal of desired frequency.

According to an embodiment of the present invention, it is possible to provide a semiconductor integrated circuit device that can easily oscillate a clock signal of a desired frequency.

BRIEF DESCRIPTION OF THE DRAWINGS

Fig. 1 is a block diagram showing the configuration of an electronic device;
Fig. 2 is a plan view showing an arrangement on a substrate according to a first embodiment;
Fig. 3 is a block diagram showing the configuration of a semiconductor integrated circuit device according to the first embodiment;
Fig. 4 is a circuit diagram showing the principle according to the first embodiment;
Figs. 5A to 5C are voltage waveform diagrams showing the principle according to the first embodiment;
Fig. 6 is a characteristic diagram showing the relationship between delay time and capacitance value according to the first embodiment;
Fig. 7 is a block diagram showing the measurement of the delay time according to the first embodiment;
Fig. 8 is a block diagram showing the setting of the capacitance value according to the first embodiment;
Fig. 9 is a block diagram showing the configuration of a board according to a second embodiment;
Fig. 10 is a block diagram showing the configuration of a board according to a variation of the second embodiment;
Fig. 11 is a characteristic diagram showing the relationship between delay time and capacitance value according to a third embodiment;
Fig. 12 is a circuit diagram showing the configuration of the main part of a semiconductor integrated circuit device according to the third embodiment;
Fig. 13 is a circuit diagram showing the configuration of the main part of the semiconductor integrated circuit device according to the third embodiment;
Fig. 14 is a block diagram showing the configuration of a board according to a fourth embodiment;
Fig. 15 is a block diagram showing the configuration of a measurement circuit according to the fourth embodiment;
Fig. 16 is a block diagram of another configuration of the measurement circuit according to the fourth embodiment;
Figs. 17A to 17F are timing diagrams showing the operation of the measurement circuit according to the fourth embodiment;
Fig. 18 is a block diagram showing the configuration of a board according to a variation of the fourth embodiment;
Fig. 19A is a block diagram showing the configuration of a board according to a fifth embodiment;
Fig. 19B is a table diagram showing the configuration of the board according to the fifth embodiment;
Fig. 20A is a block diagram according to a variation of the fifth embodiment; and
Fig. 20B is a table diagram according to the fifth embodiment.

DETAILED DESCRIPTION

Hereinafter, preferred embodiments of the present invention will be described in detail with reference to the accompanying drawings. Note that in all the drawings for explaining the embodiments, the same reference numerals are given in principle to the same components, and the repetitive description thereof will be omitted.

First Embodiment

<Electronic device>

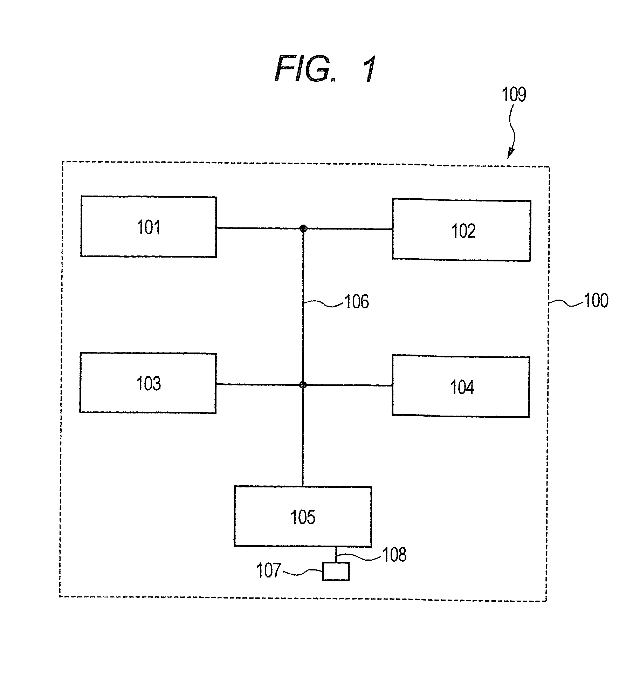

First, the configuration of an electronic device according to a first embodiment will be described. In some embodiments described below, it is assumed that the electronic device has the configuration shown in Fig. 1 as an example. In Fig. 1, reference numeral 109 denotes an electronic device. The electronic device 109 includes a wiring pattern formed in a substrate 100 (the area surrounded by a dashed line), a plurality of semiconductor integrated circuit devices 101 to 105 mounted in the substrate 100, a crystal oscillator 107 mounted in the substrate 100, a plurality of passive elements (not shown) mounted in the substrate 100, and the like. In Fig. 1, reference numerals 106 and 108 show examples of wiring patterns formed in the substrate 100. The wiring pattern 106 shown in Fig. 1 is an example of the wiring pattern for electrically coupling the semiconductor integrated circuit devices 101 to 105 to each other. The wiring pattern 108 shows an example of the wiring pattern for electrically coupling the semiconductor integrated circuit device 105 and the crystal oscillator 107 to each other.

Of course, the semiconductor integrated circuit devices 101 to 105, the crystal oscillator 107, and the wiring patterns 106 and 108, which are shown in Fig. 1, are an example. The number of pieces and/or the arrangement, and the like, of the respective components are not limited to this example. Further, in Fig. 1, the electrical coupling of the external terminals of the semiconductor integrated circuit devices 101 to 105 to the respective wiring patterns 106 and 108, as well as the electrical coupling of the terminal of the crystal oscillator 107 to the wiring pattern 108 are simplified. However, the external terminals of the respective semiconductor integrated circuit devices 101 to 105 as well as the external terminal of the crystal oscillator 107 are electrically coupled to the wiring patterns 106 and 108, respectively, for example, by means of solder.

The semiconductor integrated circuit device 105 is combined with the crystal oscillator 107 through the wiring pattern 108. The semiconductor integrated circuit device 105 has a function to oscillate a clock signal of a predetermined (desired) frequency by use of the crystal oscillator 107. The oscillated clock signal of predetermined frequency is used to operate a circuit block placed inside the semiconductor integrated circuit device 105. Further, the oscillated clock signal can also be supplied to the other semiconductor integrated circuit devices 101 to 104, to be used to operate these semiconductor integrated circuit devices.

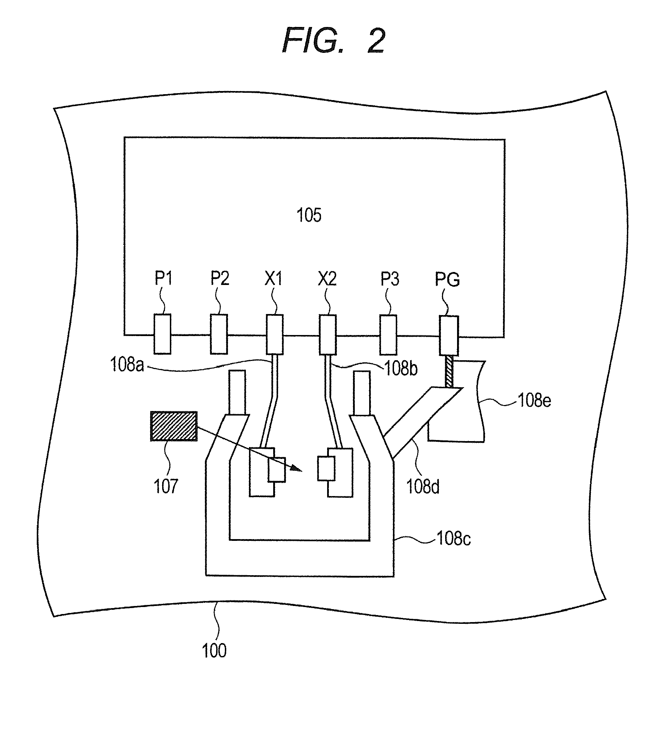

Fig. 2 is a plan view mainly showing the area in which the semiconductor integrated circuit device 105 is located in the substrate 100 shown in Fig. 1. The semiconductor integrated circuit device 105 has a plurality of external terminals. In Fig. 2, external terminals P1 to P3, PG, X1, and X2 are shown as an example. Although the details will be described later, the external terminals X2 (first external terminal) and X1 (second external terminal) are coupled with the external terminals (terminals) of the crystal oscillator 107, respectively. Further, the external terminal PG is supplied with a ground voltage of the circuit to the semiconductor integrated circuit device 105.

A plurality of lines 108a to 108e, each having a unique pattern shape, are formed in the substrate 100. The lines 108a to 108e are shown as the wiring pattern 108 in Fig. 1. The external terminal X2 of the semiconductor integrated circuit device 105 is electrically coupled to the line 108b, and the external terminal X1 is electrically coupled to the line 108a. Each of the lines 108a and 108b forms a pattern with a flat and wide area (on the lower side in the figure). Each of the external terminals of the crystal oscillator 107 is electrically coupled to the wide area.

Fig. 2 shows the state before the crystal oscillator 107 is coupled to the lines 108a and 108b. The crystal oscillator 107 is coupled to the lines 108a and 108b in such a way that, in Fig. 2, the crystal oscillator 107 is moved in the direction shown by the arrow, and the area in which the external terminals of the crystal oscillator 107 and the lines 108a, 108b overlap is fixed by solder. In this way, the external terminals of the crystal oscillator 107 are electrically coupled to the lines 108a and 108b, respectively. The line 108c is formed over the substrate 100 so as to surround the area in which the crystal oscillator 107 is fixed. The line 108c is formed over the substrate 100 so as to surround the periphery of the area in which the crystal oscillator 107 is fixed. The line 108c is coupled to the line 108e of the ground voltage Vs, together with the external terminal PG of the semiconductor integrated circuit device 105, through the line 108d. In this way, the ground voltage Vs propagates along the line 108e and is supplied to the external terminal PG of the semiconductor integrated circuit device 105. At the same time, the ground voltage Vs is also supplied to the line 108c surrounding the crystal oscillator 107. By converting the line 108c surrounding the crystal oscillator 107 into the ground voltage Vs, it is possible to prevent the noise or other disturbance caused by the operation of the crystal oscillator 107 from propagating to other parts.

Note that the lines 108a to 108e are formed in one main surface of the substrate 100. In the back surface (the surface facing the one main surface) of the substrate 100 corresponding to the area in which the crystal oscillator 107 is located, a metal wiring is formed, but the present invention is not particularly limited to this. The meal wiring formed in the back surface reduces the emission of the noise the crystal oscillator 107 generates from the back surface side of the substrate 100. Note that in the following description, the substrate in which the wiring pattern is formed may also be referred to as the board.

<Configuration of the semiconductor integrated circuit device 105>

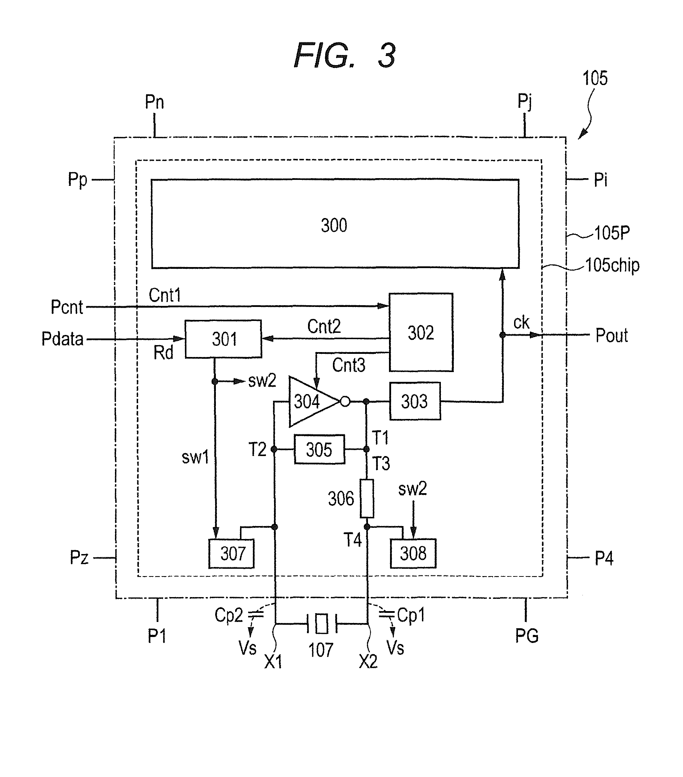

Next, a description will be given of the configuration of the semiconductor integrated circuit device 105 having a function of oscillating a clock signal of a predetermined frequency by use of the crystal oscillator 107. Fig. 3 is a block diagram showing the configuration of the semiconductor integrated circuit device 105 according to the embodiment. In Fig. 3, an area 105P surrounded by a dot-dashed line represents the package of the semiconductor integrated circuit device 105. Further, an area 105chip surrounded by a dashed line represents a semiconductor chip produced by the well-known semiconductor production techniques. In other words, the semiconductor integrated circuit device 105 is configured in such a way that a plurality of circuit blocks are formed in one semiconductor chip 105chip by the well-known semiconductor production techniques, and are sealed by the package 105P. As described above, the semiconductor integrated circuit device 105 is provided with a plurality of external terminals (lead terminals, ball terminals). In Fig. 3, these external terminals are shown projecting from the package 105P. Further, in Fig. 3, P1 to Pz, X2, X1, PG, Pout, Pcnt, and Pdata are shown as an example of the external terminals. In Fig. 3, only the external terminals X2, X1, Pout, Pcnt, and Pdata related to the description are shown as being coupled to the semiconductor chip 105chip. However, the remaining external terminals are also coupled to the semiconductor chip 105chip.

The semiconductor integrated circuit device 105 has not only the function of oscillating a clock signal of a predetermined frequency by use of the crystal oscillator 107, but also a specific function to achieve a function required for the electronic device. The semiconductor integrated circuit device 105 shown in Fig. 3 includes circuit blocks, which are roughly classified into two blocks: a circuit block for achieving the specific function, and a circuit block for configuring an oscillator circuit by use of the crystal oscillator 107. In Fig. 3, the circuit block for achieving the specific function is designated by reference numeral 300. Then, the circuit block for configuring the oscillator circuit is designated by reference numerals 301 to 308. In this embodiment, a clock signal ck of predetermined frequency formed by the oscillator circuit is supplied to the circuit block 300 and to the external terminal Pout. Although not particularly limited, the circuit block 300 operates according to the clock signal ck to perform a predetermined function. The clock signal ck supplied to the external terminal Pout is, for example, supplied to the other semiconductor integrated circuit devices 101 to 104 and is used in the other semiconductor integrated circuit devices.

Next, a description will be given of the circuit blocks 301 to 308 that operate as the oscillator circuit by use of the crystal oscillator 107.

In Fig. 3, reference numeral 304 denotes an inverter circuit (active circuit) whose operation is controlled by an activation signal Cnt3. When viewed as the oscillator circuit, the inverter circuit 304 functions as a negative resistance amplifier to keep the oscillation going. Reference numerals 305 and 306 respectively denote impedance elements. When viewed as the oscillator circuit, 305 functions as a feedback impedance element and 306 functions as an amplitude control impedance element. The feedback impedance element 305 has a pair of terminals T1 (first terminal) and T2 (second terminal). Also the amplitude control impedance element 306 has a pair of terminals T3 (third terminal) and T4 (fourth terminal). The inverter circuit 304 is coupled in parallel to the feedback impedance element 305. In other words, the input of the inverter circuit 304 is coupled to the terminal T2 of the feedback impedance element 305, and the output of the inverter circuit 304 is coupled to the terminal T1 of the feedback impedance element 305. Further, the terminal T3 of the amplitude control impedance element 306 is coupled to the terminal T1 of the feedback impedance element 305. Then, the terminal T4 is coupled to the external terminal X2 (first external terminal).

The terminal T2 (second terminal) of the feedback impedance element 305 is coupled to the external terminal X1 (first terminal). Further, the terminal T1 (first terminal) of the feedback impedance element 305 can also be seen as being coupled to the external terminal X2 (first external terminal) through the amplitude control impedance element 306. In Fig. 3, reference numerals 307 and 308 denote variable capacitance circuits, respectively. When viewed as the oscillator circuit, the variable capacitance circuits function as load capacitances. The variable capacitance circuit 307 (second variable capacitance circuit) is coupled between the terminal T2 of the feedback impedance element 305 and the ground voltage, in which the capacitance value between the terminal T2 and the ground voltage changes according to the capacitance control signal sw1. Further, the variable capacitance circuit 308 (first variable capacitance circuit) is coupled between the terminal T4 of the amplitude control impedance element 306 and the ground voltage, in which the capacitance value between the terminal T4 and the ground voltage changes according to the capacitance value control signal sw2.

The clock signal output from the inverter circuit 304 is supplied to a buffer circuit 303. The buffer circuit 303 has a predetermined threshold voltage, and compares the voltage of the clock signal output from the inverter circuit 304 with the predetermined threshold voltage as a reference voltage. Then, the buffer circuit 303 shapes the clock signal from the inverter circuit 304, and outputs the shaped clock signal as the clock signal ck. In this way, the shaped clock signal ck is supplied to the circuit block 300 and to the external terminal Pout. In Fig. 3, reference numeral 301 denotes a register (configuration circuit). The register 301 receives a capacitance data Rd from the external terminal Pdata, generates the capacitance value control signals sw1 and sw2 corresponding to the capacitance data Rd, and supplies to the variable capacitance circuits 307 and 308. In this way, the capacitance values of the variable capacitance circuits 307 and 308 are converted to the values according to the capacitance data Rd.

In Fig. 3, reference numeral 302 denotes a control circuit. The control circuit 302 receives a capacitance control signal Cnt1 from the external terminal Pcnt. Then, the control circuit 302 generates the activation signal Cnt3 and register control signal Cnt2, and supplied to the inverter circuit 304 and the register 301. The control circuit 302 receives the capacitance control signal the Cnt1 and puts the inverter circuit 304 into an inactive state. In this way, the inverter circuit 304 will not output a signal inverted from the signal supplied to its input. In other words, at this time, the signal supplied to the external terminal X1 or the terminal T2 of the feedback impedance element 305 is transmitted to the terminal T1 of the feedback impedance element 305 only through the feedback impedance element 305. In this way, it is possible to obtain an observation signal according to the value of the capacitance coupled to the terminal T1 of the feedback impedance element 305, including the parasitic capacitance associated with the external terminal X2, which will be described in detail below.

Further, when receiving the capacitance control signal Cnt1, the control circuit 302 supplies the register control signal Cnt2 to the register 301. When receiving the register control signal Cnt2, the register 301 generates the capacitance value control signals sw1, sw2 according to the capacitance data Rd and supplies to the variable capacitance circuits 307, 308 as described above.

The crystal oscillator 107 has a pair of terminals (external terminals). One of the pair of terminals is coupled to the external terminal X2 of the semiconductor integrated circuit device 105, and the other terminal is coupled to the external terminal X1. When the capacitance control single Cnt1 is not supplied to the control circuit 302 through the external terminal Pcnt, namely, in the case of normal operation, the control circuit 302 generates the activation signal Cnt3 so that the inverter circuit 304 is put into an active state. In this way, the inverter circuit 304 inverts and outputs the signal supplied to the input of the inverter circuit 304. In this way, the clock signal corresponding to the resonance frequency of the crystal oscillator 107 is generated by the oscillator circuit that is configured by the inverter circuit 304, the negative feedback impedance element 305, the variable capacitance circuits 307 and 308, the amplitude control impedance element 306, and the crystal oscillator 107. In other words, the clock signal corresponding to the resonance frequency of the crystal oscillator 107 is oscillated.

<Capacitance value measurement by the delay time>

There is a parasitic capacitance in the substrate 100 and/or the wiring pattern 108. In Fig. 3, parasitic capacitances Cp1, Cp2 associated with the external terminals X2, X1 are schematically shown by the dashed line. Each of the parasitic capacitances Cp1 and Cp2 includes the parasitic capacitance of the wiring pattern coupled to the external terminals X2 and X1, respectively. The frequency of the clock signal ck generated by the oscillator circuit described above varies depending on the values of the parasitic capacitances Cp1 and Cp2. Further, as described above, the capacitance value of the parasitic capacitances Cp1 and Cp2 changes when the substrate 100 and/or the wiring pattern 108 is changed. The capacitance value of the Cp1 and Cp2, which is for example 4 pF, is changed to 2 pF when the wiring pattern is changed. In order to generate the clock signal ck of desired frequency in response to the change in the capacitance value of the parasitic capacitance, it is necessary to change the capacitance value of the variable capacitance circuits 308 and 307, for example, from 6 pF to 8 pF. In other words, in this example, the parasitic capacitance is reduced due to the change in the board, so that the capacitance value of the variable capacitance circuits 308 and 307 is increased to compensate so that the value of the capacitance including the parasitic capacitance is the same before and after the change in the board.

In the first embodiment, it is possible to generate a clock signal of a desired frequency by indicating (measuring) the value of the capacitance including the parasitic capacitance by the delay time, and by adjusting the capacitance value of the variable capacitance circuits 308 and 307 so that the delay time becomes a predetermined (desired) value. Here, a description will be given of the principle of indicating and measuring the capacitance value by the delay time.

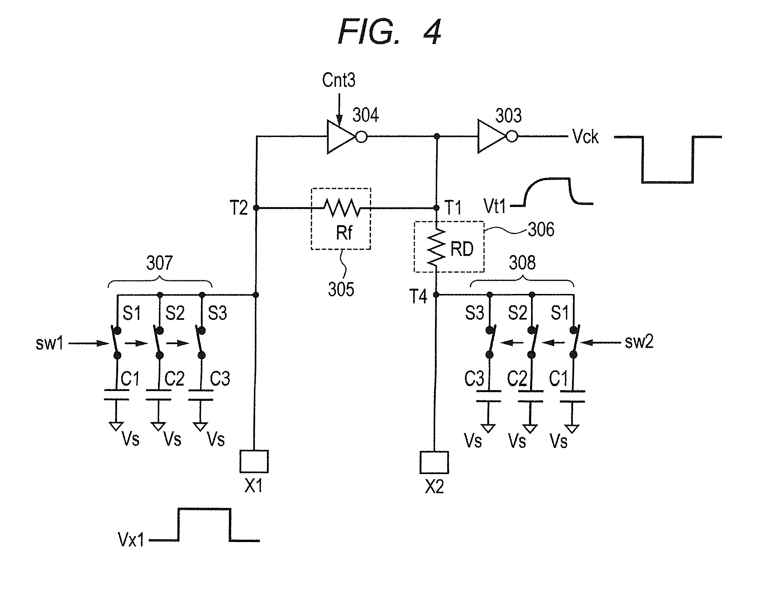

Fig. 4 is a circuit diagram showing the principle of indicating the capacitance value by the delay time. First, the correspondence between Fig. 4 and Fig. 3 will be described. Fig. 4 is a circuit diagram showing an example of the inverter circuit 304, the feedback impedance element 305, the amplitude control impedance element 306, the variable capacitance circuits 307 and 308, and the buffer circuit 303, which are shown in Fig. 3. Of course, the same parts are designated by the same reference numerals in Figs. 3 and 4.

In Fig. 4, the feedback impedance element 305 is formed by a feedback resistive element Rf, and the amplitude control impedance element 306 is formed by an amplitude control resistive element RD. Further, in this example, the variable capacitance circuits 307 and 308 are formed by capacitance elements C1 to C3 and switches S1 to S3, respectively. In other words, the variable capacitance circuit 308 has three series circuits coupled in parallel to each other between the terminal T4 of the amplitude control resistive element RD and the ground voltage Vs. Each of the series circuits has the same configuration, but the present invention is not particularly limited to this. When citing the series circuit shown in the rightmost side of the figure, the switch S1 and the capacitance element C1, which are switched and controlled by the capacitance value control signal sw2, are coupled in series between the terminal T4 and the ground voltage Vs. In the remaining two series circuits, the switches S2 and S3 are coupled in series to the capacitance elements C2 and C3, respectively. Although not particularly limited, the capacitance values of the capacitance elements 1 to C3 are different from each other in this example. Also the variable capacitance circuit 307 has the same configuration as the variable capacitance circuit 308. However, the switches S1 to S3 in the variable capacitance circuit 307 are switched and controlled by the capacitance value control signal sw1.

Each of the capacitance value control signals sw1 and sw2 is shown as one signal but includes a plurality of capacitance value control signals. Thus, these capacitance control signals are collectively referred to as the capacitance control signals sw1 and sw2. In each variable capacitance circuit 308 (307), the switches S1 to S3 are switched and controlled separately by different capacitance control signals. In this way, the three capacitance elements C1 to C3 in the variable capacitance circuit 308 (307) are selected, and the selected capacitance elements are electrically coupled between the terminal T4 (T2) and the ground voltage Vs. For example, it is assumed that the capacitance values of the capacitance elements C1, C2, C3 are 2 pF, 4 pF, 8 pF, respectively. In this case, the capacitance value of the variable capacitance circuit 308 (307) can be changed between 0 pF to 14 pF, by selecting from the switches S1 to S3 on a timely basis according to the capacitance value control signal. In other words, it is possible to change the capacitance value of the variable capacitance circuit 308 (307) coupled between the terminal T4 (T2) and the ground voltage Vs, between 0 pF to 14 pF according to the capacitance value control signal sw2 (sw1).

The resistance value R of the feedback resistive element Rf is set to, for example, 200 K ohms. The resistance value of the amplitude control resistive element RD is set to, for example, 2 K ohms because the amplitude of the clock signal is much more limited than expected when the resistance value is set to a too high value. In general, the resistance value of the amplitude control resistive element RD configuring the oscillator circuit is set to about one hundredth of the resistance value R of the feedback resistive element Rf.

Fig. 4 shows the waveforms of three voltages Vx1, Vt1, and Vck, together with a circuit diagram. In each of the waveformes of the three voltages Vx1, Vt1, and Vck, the horizontal axis represents the time and the vertical axis represents the voltage. The waveform of the voltage Vx1 is the voltage waveform of the measurement signal (first measurement signal) supplied to the external terminal X1. Further, the waveform of the voltage Vt1 shows the voltage change at the terminal T1 of the feedback resistive element Rf. Then, the waveform of the voltage Vck shows the voltage waveform of the clock signal ck.

When the measurement signal whose voltage value changes into a rectangular shape along with the time, as shown in the voltage waveform Vx1, is supplied to the external terminal X1, the voltage waveform occurring in the external terminal X2 is expressed by the equation (1). Here, Vx2 represents the voltage occurring in the external terminal X2, V0 represents the voltage of the voltage waveform Vx1, and T represents the time constant (RC) given by the resistance value R of the feedback resistive element Rf as well as the capacitance value C of the variable capacitance circuit 308.

In this embodiment, upon measurement of the capacitance value of the capacitance element the oscillator circuit has, including the parasitic capacitance associated with the external terminals X1, X2 to which the crystal oscillator is coupled, the inverter circuit 304 is put into an inactive state according to the activation signal Cnt3. Thus, the inverter circuit 304 does not invert the voltage at the terminal T2 and does not transmit to the terminal T1. For this reason, the resistance component at the time constant T in the equation (1) is determined by the feedback resistive element Rf and the amplitude control resistive element RD. Further, the resistance value of the amplitude control resistive element RD is about one hundredth of the resistance value R of the feedback resistive element Rf as described above, so that the resistance value of the amplitude control resistive element RD can be ignored. Thus, the resistance component at the time constant T of the equation (1) is the resistance value R of the feedback resistive element Rf.

$$\text{Equation } 1$$

$$Vx2 = V0(1 - e^{-\frac{t}{T}})$$

Further, since the resistance value of the amplitude control resistive element RD can be ignored, the change in the voltage at the terminal T1 of the feedback resistive element Rf is the same as the change in the voltage at the external terminal X2. Thus, the voltage waveform Vt1 at the terminal T1 shown in Fig. 4 can also be regarded as the voltage waveform at the external terminal X2. In other words, it is possible to regard the voltage Vx2 shown in the equation (1) as the voltage Vt1 of the terminal T1.

The voltage waveform Vck of the clock signal ck varies depending on whether or not the voltage Vt1 (=Vx2) at the terminal T1 exceeds the threshold voltage VT (logic threshold voltage) of the buffer circuit 303. A delay time t from when the rectangular wave (measurement signal) supplied to the external terminal X1 reaches the voltage V0 to when the voltage of the clock signal ck, which is the output of the buffer circuit 303, is inverted is expressed by the equation (2). As can be understood from the equation (2), the delay time t is linear to the time constant (T:RC).

$$t = -RC \times \ln(1 - \frac{VT}{V0})$$

$$\text{Equation } 2$$

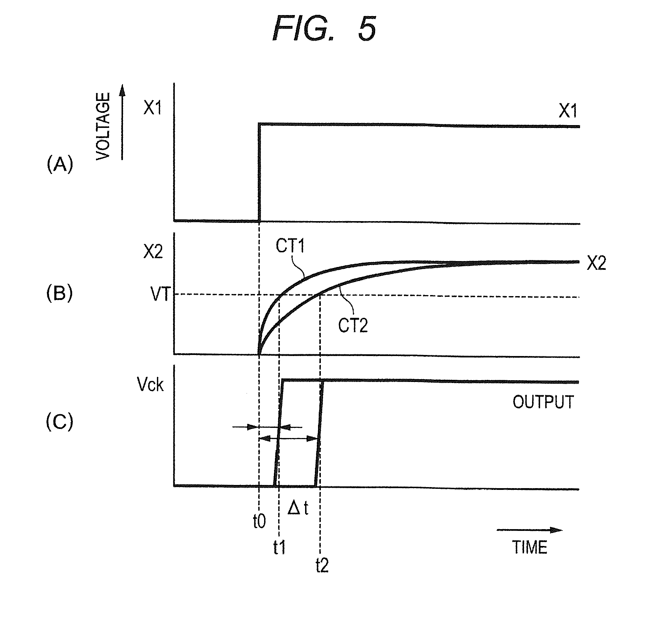

Figs. 5A to 5C are voltage waveform diagrams showing the principle of measuring the capacitance value by the delay time. Fig. 5A shows the voltage waveform of the measurement signal (first measurement voltage) supplied to the external terminal X1 in Fig. 4. Fig. 5B shows the voltage change at the external terminal X2. As described above, the voltage at the external terminal X2 is practically the same as the voltage at the terminal T1. Thus, it can also be seen that Fig. 5B shows the voltage waveform at the terminal T1. Further, Fig. 5C shows the voltage waveform of a clock signal Vck which is the output of the buffer circuit 303.

In Fig. 5A, the measurement signal (X1 in the figure) supplied to the external terminal X1 changes from the ground voltage to the voltage V0 at time t0. In response to the change in the measurement signal (X1), the voltage at the external terminal X2 (=terminal T1) increases according to the time constant (RC) determined by the resistance value of the feedback resistive element Rf, and by the capacitance value of the variable capacitance circuit 308 as well as the capacitance value of the parasitic capacitance Cp1. Fig. 5B shows the case in which the capacitance value of the variable capacitance circuit 308 is set to CT1 and to CT2 , respectively. For example, the capacitance value of the variable capacitance circuit 308 is 2 pF for the capacitance value CT1, and capacitance value is 4 pF for the capacitance value CT2. In Fig. 5B, the threshold voltage VT of the buffer circuit 303 is also shown by the dashed line. When the voltage (X2) at the external terminal X2 (terminal T1) exceeds the threshold voltage VT, the voltage of the clock signal ck, which is the output of the buffer circuit 303, changes as shown in Fig. 5C. In this example, the clock signal ck is the observation signal (first observation signal).

In other words, when the capacitance value of the variable capacitance circuit 308 is set to CT1, the voltage Vck of the clock signal ck rises to a high level at time t1. On the other hand, when the capacitance value of the variable capacitance circuit 308 is set to CT2, the voltage Vck of the clock signal ck rises to a high level at time t2. In other words, the voltage of the clock signal ck changes after the delay time (t1 or t2) that is determined by the combined capacitance of the parasitic capacitance Cp1 and the variable capacitance circuit 308, from the time (t0) when the measurement signal (X1) is supplied. In Fig. 4, the buffer circuit 303 is formed by a one-stage inverter circuit, so that the voltage of the clock signal ck falls when the voltage of the external terminal X2 increases, which is, however, shown as a rising voltage in Fig. 5 in order to simplify the explanation.

The delay times, namely, the time intervals from time t0 to time t1 and from time t0 to time t2, are determined by the combined capacitance of the parasitic capacitance and the variable capacitance circuit 308. In other words, the delay time corresponds to the capacitance value including the parasitic capacitance. Because the combined capacitance includes the capacitance value of the parasitic capacitance, the delay time does not correspond to the absolute value of the capacitance value of the variable capacitance circuit 308. However, it is possible to obtain the relative value of the capacitance value of the variable capacitance circuit 308, in which the influence of the capacitance value of the parasitic capacitance is removed, by changing the capacitance value of the variable capacitance circuit 308 to obtain delay times, and by calculating the difference ($\Delta$t) of the obtained delay times. In this way, it is also possible to test the variable capacitance of the variable capacitance circuit 308 (307).

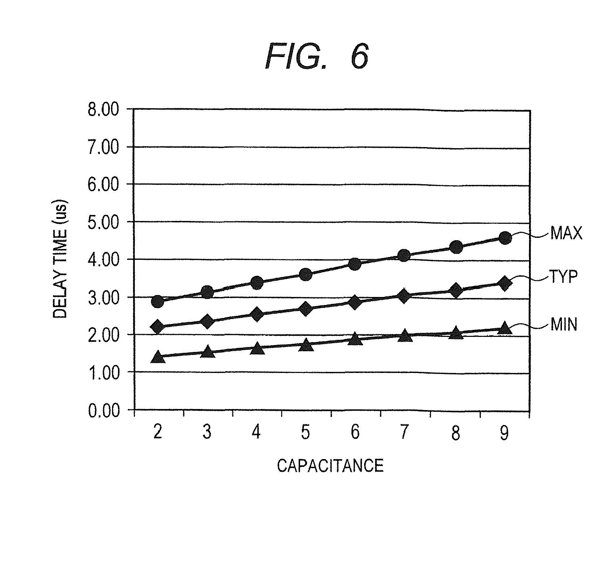

Fig. 6 is a characteristic diagram showing the principle of measuring the capacitance value by the delay time. Fig. 6 is a characteristic diagram showing the change in the delay time when the capacitance value of the variable capacitance circuit 308 is changed in series. In Fig. 4, the description has assumed that the range of the capacitance variable of the variable capacitance circuits 308 and 307 is between 2 pF to 14 pF. However, Fig. 6 shows the delay time when the capacitance of the variable capacitance circuit 308 is sequentially changed from 2 pF to 10 pF on a trial basis. In Fig. 6, there are three types of change in the delay time when the capacitance value of the variable capacitance circuit 308 is changed in series. Of the three types, the characteristic represented by TYP shows the characteristic when the buffer circuit 303, the insulated gate type transistors (hereinafter referred to as MOSFETs) configuring the switches S1 to S3 and the like, and the capacitance elements C1 to C3 or other components are produced in the normal state. Further, MAX represents the characteristic when the fluctuations are the largest in the MOSFETs and the capacitance elements C1 to C3, which are described above. MIN represents the characteristic when the fluctuations are the smallest in the MOSFET and the capacitance elements C1 to C3, which are described above. As shown in Fig. 6, when the capacitance value of the variable capacitance circuit 308 is increased, the delay time is also linearly increased in any of the characteristics.

Fig. 6 shows the characteristics when the measurement signal (X1) is raised from the ground voltage Vs to a predetermined voltage (V0), which are the same as the characteristics when the measurement signal (X1) is decreased from the predetermined voltage (V0) to the ground voltage Vs. In other words, also in the case of decreasing the measurement signal (X1), the delay time linearly increases when the capacitance value of the variable capacitance circuit is increased.

As shown in Fig. 6, the relationship between the capacitance value of the variable capacitance circuit and the delay time is linearly proportional. Thus, the capacitance coupled to the external terminal X2, namely, the value of the combined capacitance of the variable capacitance circuit 308 and the parasitic capacitance Cp1 can be indicated (measured) by the delay time and can be specified by the delay time.

<Capacity value setting by the delay time>

In the foregoing, it has been described that the value of the capacitance combined with the external terminal X2 can be measured by the delay time and can be specified by the time. Next, the setting of the capacitance value by the delay time will be described.

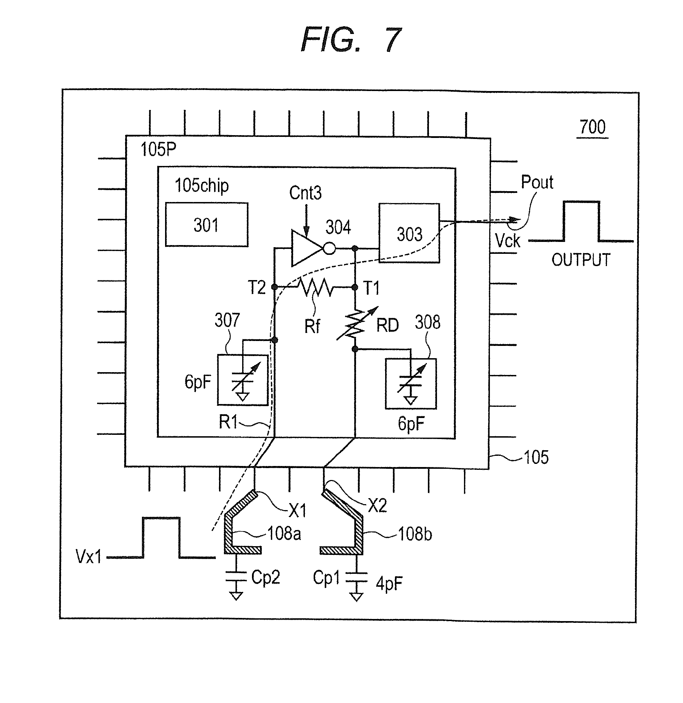

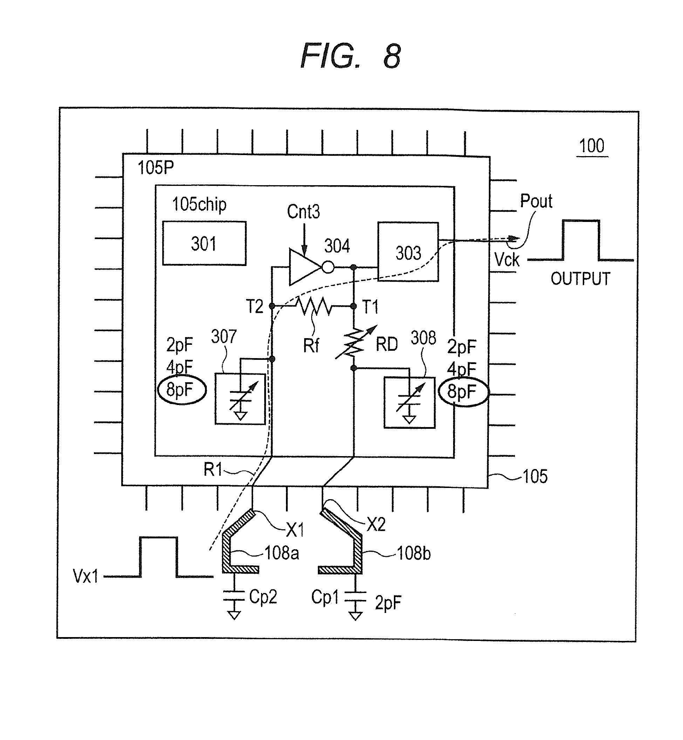

Fig. 7 is a block diagram showing the measurement of the delay time, namely, the signal propagation delay time. Further, Fig. 8 is a block diagram showing the selection and setting of the capacitance according to the delay time.

Fig. 7 shows an evaluation board that is provided, for example, by the semiconductor manufacturer. The evaluation board includes a substrate 700 similar to the substrate 100 shown in Fig. 1, and a wiring pattern formed in the substrate. Further, the evaluation board of this example is provided with a plurality of semiconductor integrated circuit devices mounted in the substrate 700. The semiconductor integrated circuit device 105 shown in Figs. 3 and 4 is included in the semiconductor integrated circuit devices mounted in the substrate 700. Fig. 7 only shows the semiconductor integrated circuit device 105 and the associated lines 108a and 108b. Further, the semiconductor integrated circuit device 105 shown in Fig. 7 has the configuration shown in Figs. 3 and 4, however, only the part related to the description is shown in Fig. 7.

In this embodiment, the semiconductor manufacturer measures the delay time corresponding to the capacitance value that can form the clock signal ck of desired frequency in the evaluation board, and provides the measured delay time to the electronic device manufacturer.

In other words, the semiconductor manufacturer couples the crystal oscillator 107 between the lines 108a and 108b formed over the substrate 700, and determines the capacitance value of the variable capacitance circuit 308 so as to be able to form the clock signal ck of desired (predetermined) frequency. At this time, the activation signal Cnt3 is supplied to the inverter circuit 304 from the control circuit 302 so that the inverter circuit 304 can be put into an active state. Fig. 7 shows the case in which the clock signal ck of desired frequency is formed when the capacitance value of each of the variable capacitance circuits 308 and 307 is 6 pF. At this time, the parasitic capacitance Cp1 associated with the external terminal X2 is set to 4 pF for descriptive convenience.

If it is determined that 6 pF is appropriate for the capacitance value of each of the variable capacitance circuits 308 and 307, the control circuit 302 controls to maintain the capacitance value control signals sw1 and sw2 with respect to the register 301 so that the capacitance values of the variable capacitance circuits 308 and 307 is continuously 6 pF.

Next, the control circuit 302 is instructed to perform the measurement by the capacitance control signal Cnt1. In this way, the control circuit 302 puts the inverter circuit 304 into an inactive state by the activation signal Cnt3.

Then, the control circuit 302 supplies a measurement signal (voltage Vx1) changing to a rectangular shape, to the external terminal X1. The measurement signal propagates through a signal transmission path R1 shown by the dashed line in Fig. 7, and reaches the external terminal Pout. In this embodiment, the clock signal ck output from the external terminal Pout becomes the observation signal. Fig. 7 shows the waveform of the voltage Vx1 of the measurement signal, as well as the waveform of the voltage Vck of the observation signal formed in response to the measurement signal. The propagation delay time from the rising of the measurement signal supplied to the external terminal X1 to the rising of the observation signal, is the time corresponding to the capacitance value of the capacitance combined with the external terminal X2 as described above. In other words, in this example, the propagation delay time is the delay time corresponding to 10 pF which is the value of the combined capacitance of the capacitance value 6 pF in the variable capacitance circuit 308 and the capacitance value 4 pF of the parasitic capacitance Cp1.

Note that when the propagation delay time is measured, the crystal oscillator 107 may be or may not be coupled between the lines 108a and 108b. Of course, it is also possible that one external terminal of the crystal oscillator 107 is coupled only to the line 108b (external terminal X2). This is because the parasitic capacitance associated with the external terminal of the crystal oscillator 107 is smaller than the parasitic capacitance associated with the lines 108a and 108b. Further, in Fig. 7, the measurement signal has the same phase as that of the observation signal. However, their phases may be inverted as shown in Fig. 4.

In this way, the semiconductor manufacturer measures the delay time corresponding to the capacitance value that can form the clock signal ck of predetermined frequency in the evaluation board. Then, the semiconductor manufacturer also presents the measured delay time, for example, when providing the semiconductor integrated circuit device 105 to the electronic device manufacturer. In this case, the capacitance value corresponding to the presented delay time is the combined capacitance value of the capacitance element combined with the external terminal X. In other words, this is the combined value of the capacitance value of the variable capacitance circuit 308 and the capacitance value of the parasitic capacitance Cp1 associated with the external terminal X2. Here, the parasitic capacitance associated with the external terminal X2 includes the parasitic capacitance of the line 108b.

Fig. 8 shows the substrate 100 produced in the electronic device manufacturer. The substrate 100 shown in Fig. 8 is configured in such a way that a plurality of semiconductor integrated circuit devices including the semiconductor integrated circuit device 105, and the like are mounted in the substrate 100 as shown in Fig. 1. Similarly to Fig. 7, Fig. 8 shows only the semiconductor integrated circuit device 105 and the lines 108a and 108b. Further, the semiconductor integrated circuit device 105 has the same configuration as the one shown in Figs. 3 and 5. However, the part related to the description is only shown in Fig. 8.

The control circuit 302 is instructed by the capacitance control signal Cnt1 to generate the activation signal Cnt3 so as to put the inverter circuit 304 into an inactive state. The control circuit 302 supplies the measurement signal with the rectangular waveform of the voltage Vck to the external terminal X1, while changing the capacitance value of the variable capacitance circuit 308, according to the capacitance value control signal sw2 formed by the register 301. Then, the control circuit 302 observes the clock signal ck (observation signal) output from the external terminal Pout. For example, the control circuit 302 sets the capacitance value of the variable capacitance circuit 308 to 2 pF according to the capacitance value control signal sw2, and supplies the measurement signal (voltage Vx1) to the external terminal X1. Then, in response to the measurement signal at this time, the control circuit 320 observes the observation signal (voltage Vck) output from the output terminal. Here, in the observation, the transmission delay time from the rising of the measurement signal to the rising of the observation signal is measured. This observation is performed by changing the capacitance value of the variable capacitance circuit 308. Fig. 8 shows an example of the capacitance values which are changed according to the variable capacitance circuits 308 and 307, as 2 pF, 4 pF, and 8 pF.

In the observation, when the transmission delay time which is the same or close to the delay time presented by the semiconductor manufacturer is observed, the control circuit 302 issues an instruction to the register 301 to continuously set the capacitance value of the variable capacitance circuit 308 at this time. In this way, the capacitance value of the variable capacitance circuit 308 is set to form the clock signal ck of desired frequency.

The board (the substrate 100, the wiring patterns, and the components mounted in the substrate) shown in Fig. 8 in the electronic device manufacturer is different from the evaluation board of the semiconductor manufacturer. For example, the material of the substrate and/or the lines, as well as the wiring patterns, and the like, are different between the two boards. Thus, the parasitic capacitance associated with the external terminal X2 is different even with the same semiconductor integrated circuit device 105. For example, in the board of the electronic device manufacturer, the capacitance Cp1 of the line 108b may also be 2 pF as shown in Fig. 8. In such a case, the value of the combined capacitance combined with the external terminal X2 is 8 pF (6 pF+2 pF), even when the value is set so that the capacitance value of the variable capacitance circuit 308 becomes 6 pF similar to the setting in the evaluation board of the semiconductor manufacturer. Thus, it is difficult to form the clock signal ck of desired frequency.

However, the delay time is obtained with the combined capacitance of the parasitic capacitance associated with the external terminal X2 and the variable capacitance circuit 308, as the time constant. Then, as described in the present embodiment, the obtained delay time is matched between the evaluation board of the semiconductor manufacturer and the board of the electronic device manufacturer. Thus, the capacitance value of 8 pF is selected and set in the variable capacitance circuit 308 in the semiconductor integrated circuit device 105 in the electronic device manufacturer. In this way, in the board of the electronic device manufacturer, the combined capacitance combined with the external terminal X2 of the semiconductor integrated circuit device 105 is 10 pF (8 pF+2 pF). Thus, the same value of the combined capacitance as in the evaluation board of the semiconductor manufacturer is coupled to the external terminal X2. As a result, it is possible to form the clock signal ck of desired frequency also in the board of the electronic device manufacturer.

Further, in this case, the electronic device manufacturer can set the value of the variable capacitance circuit 308 based on the delay time presented by the semiconductor manufacturer. Thus, it is possible to eliminate the need to request on the crystal oscillator manufacturer and to prevent the delay in the production.

Note that in Figs. 7 and 8, the amplitude control resistive element RD is configured by the variable element. In this way, it is possible to control the amplitude of the clock signal.

Although the above description focused on the example of controlling the register by the control circuit 302, the present invention is not limited to this example. For example, it may be possible that the capacitance value of the variable capacitance circuit is supplied from the external terminal Pdata and is stored in the register 301 each time the observation is performed.

Second Embodiment

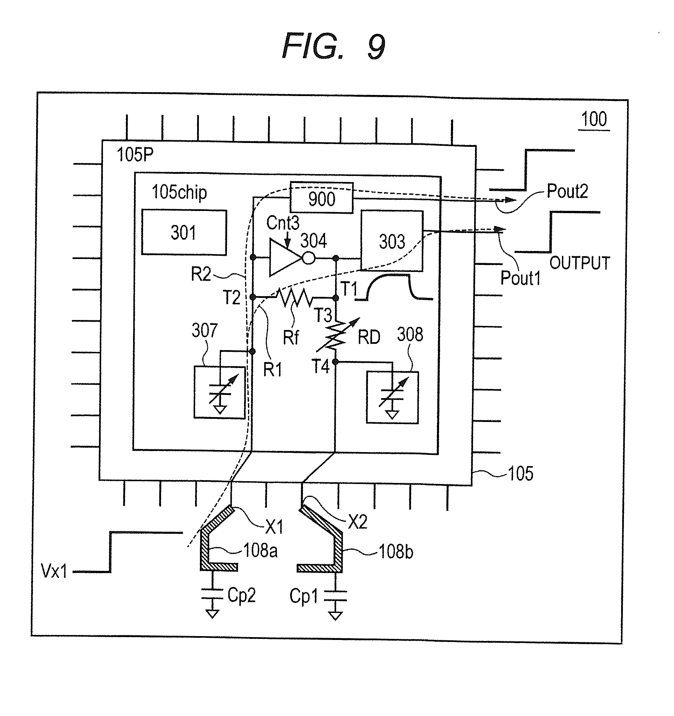

Fig. 9 is a block diagram showing the configuration of a board according to a second embodiment. Fig. 9 is similar to the configuration of the board shown in Fig. 8. Here, the description mainly focuses on the difference from Fig. 8.

One of the external terminals provided in the semiconductor integrated circuit device 105 is assigned as an external terminal Pout2 to output the observation signal. Further, the external terminal Pout descried in Fig. 8 is assigned as an external terminal Pout1. In the semiconductor chip 105chip, there is provided a buffer circuit 900 between the terminal T2 (second terminal) of the feedback resistive element Rf and the external terminal Pout2. The buffer circuit 900 has the same configuration as that of the buffer circuit 303, buffering the signal at the terminal T2 and transmitting to the external terminal Pout2.

When the inverter circuit 304 is put into an inactive state by the activation signal Cnt3 to observe the delay time, in the second embodiment, the measurement signal is transmitted to the external terminals Pout1 and Pout2, respectively, through the signal transmission paths R1 and R2 indicated by the dashed lines. In other words, the observation signal according to the time constant given by the feedback resistive element Rf, the variable capacitance circuit 308, and the parasitic capacitance associated with the external terminal X2, reaches the external terminal Pout1 through the signal transmission path R1 shown in Figs. 7 and 8. On the other hand, the measurement signal (Vx1) with a rectangular voltage waveform, which is supplied to the external terminal X1, is transmitted to the terminal T2 of the feedback resistive element Rf and reaches the external terminal Pout2 through the signal transmission path R2.

In the first embodiment, the time difference between the measurement signal supplied to the external terminal X1 and the observation signal output from the external terminal Pout, is observed as the transmission delay time. However, in the second embodiment, the observation signal corresponding to the measurement signal supplied to the external terminal X1 is output from the external terminal Pout2. Thus, it is possible to obtain the transmission delay time by obtaining the time difference between the observation signal output from the external terminal Pout2 and the observation signal output from the external terminal Pout1. In other words, it is possible to obtain the delay time by the relative difference between the observation signals, instead of the absolute value with respect to the measurement signal. Thus, the improvement in the accuracy can be achieved. Further, since the delay time is measured as the time difference between the output observation signals, it is possible to simplify the measurement in the measurement device (tester).

In Fig. 9, it is assumed that the semiconductor integrated circuit device 105 is mounted in the board of the electronic device manufacturer. However, the same effect can be obtained when the semiconductor integrated circuit device 105 is mounted in the evaluation board of the semiconductor manufacturer.

<Variation>

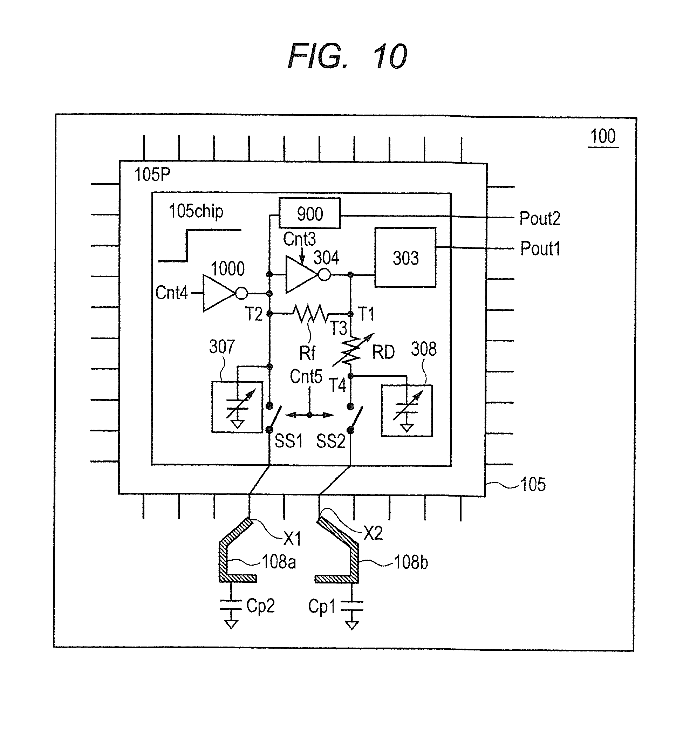

Fig. 10 is a block diagram showing the configuration of a board according to a variation of the second embodiment. The difference between Fig. 9 and Fig. 10 is in that the semiconductor chip 105chip includes: a measurement single generating circuit for generating a measurement signal; a switch circuit SS1 (isolation circuit) coupled between the terminal T2 of the feedback resistive element Rf and the external terminal X1; and a switch circuit SS2 (isolation circuit) coupled between the terminal T4 of the amplitude control resistive element RD and the external terminal X2.

In Fig. 10, although the measurement signal generating circuit is configured by an inverter circuit 1000, the present invention is not limited to this. Although not particularly limited, a measurement signal Cnt4 is supplied to the inverter circuit 1000 from the control circuit 302 (Fig. 3), and the measurement signal which is inverted from the measurement signal Cnt4 is supplied to the terminal T2 of the feedback resistive element Rf. Further, although not particularly limited, a test signal Cnt5 is supplied to the switch circuits SS1 and SS2 from the control circuit 302.

The control circuit 302 supplies the measurement signal Cnt4 to the inverter circuit 1000 when measuring the capacitance value of the combined capacitance including the capacitance combined with the external terminal X2, and when setting the capacitance value of the variable capacitance circuit 308 so as to match the presented delay time. In this way, as shown in Fig. 9, the measurement signal is supplied to the terminal T2 of the feedback resistive element Rf from the inverter circuit 1000, without supplying the measurement signal to the external terminal X1. In this case also, it is possible to obtain the time difference between the observation signals output to the external terminals Pout1 and Pout2, respectively, as the delay time. Thus, it is possible to present the delay time from the semiconductor manufacturer. While in the electronic device manufacturer, it is possible to form a clock signal of a desired frequency by setting the capacitance value of the variable capacitance circuit 308 so that the time difference between the output terminals Pout1 and Pout2 matches the presented delay time. In this variation, the need for providing the measurement single to the external terminal is eliminated, allowing the handling to be facilitated.

Further, for example, when the capacitance value of the variable capacitance circuits 308 and 307 is checked, the control circuit 302 forms a test signal Cnt5 to put the switch circuits SS1 and SS2 into an OFF state. The capacitance value is checked, for example, during the test of the semiconductor integrated circuit device 105 in the semiconductor manufacturer. The terminal T4 and the external terminal X2 as well as the terminal T2 and the external terminal X1 are electrically separated from each other by putting the switch circuits SS1 and SS2 into an OFF state. At this time, the variable capacitance circuits 308 and 307 are coupled to the terminals T1 and T2, respectively. As described above, the control circuit 302 puts the switch circuits SS1 and SS2 into an OFF state and supplies the measurement signal from the inverter circuit 1000 to the terminal T2. In this way, it is possible to measure the capacitance value of the variable capacitance circuit 308. In this case, the external terminals X1 and X2 are electrically separated from each other. Thus, it is possible to reduce the influence on the measurement value of the variable capacitance circuit 308 measured by the parasitic capacitances Cp1 and Cp2 associated with the external terminals X1 and X2.

Note that it may also be possible to provide only the switch circuit SS2 in order to measure the capacitance value of the variable capacitance circuit 308 while reducing the influence on the parasitic capacitance Cp1 associated with the external terminal X2. Of course, when performing the oscillation operation, the control circuit 302 puts the switch circuits SS1 and SS2 into an ON state. It is desirable that not only the switch circuit SS2 but also the switch circuit SS1 is provided so that the on-resistances of the switch circuits SS1 and SS2 are present when in the ON sate.

In this variation, the switch circuits SS1, SS2 and the measurement signal generating circuit (inverter 1000) are provided in the semiconductor chip 105chip. However, the switch circuits SS1 and SS2 may not be provided. When the switch circuits SS1 and SS2 are provided, it is desirable to provide the measurement signal generating circuit (inverter 1000) to form the measurement signal inside the circuit.

Third Embodiment

In the first and second embodiments, the description has focused on the measurement and setting of the combined capacitance combined with the external terminal X2 of the external terminals X1 and X2 to which the external terminal of the crystal oscillator 107 is coupled. With respect to the combined capacitance coupled to the external terminal X1, similarly to the case of the external terminal X2, it is possible to measure the value of the combined capacitance coupled to the external terminal X1 by the transmission delay time and to set the value of the combined capacitance by the transmission delay time. The third embodiment will describe the configuration to measure and set the combined capacitance combined with the external terminal X1 according to the transmission delay time.

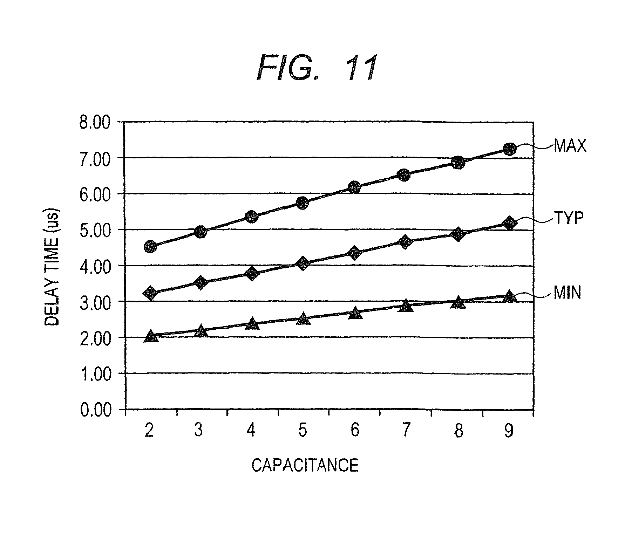

Fig. 11 is a characteristic diagram generated by supplying a measurement signal (second measurement signal) with the rectangular waveform of the voltage (Vx2) to the external terminal X2, and by measuring the delay time of the signal at the terminal T2 (second terminal) of the feedback resistive element Rf while changing the capacitance value in the variable capacitance circuit 307. Here, the delay time is the time from when the voltage (Vx2) of the measurement signal supplied to the external terminal X2 rises to when the voltage of the signal at the terminal T2 of the feedback resistive element Rf reaches a predetermined value (corresponding to the threshold voltage VT) in response to the rising of the voltage. Similar to Fig. 6, Fig. 11 shows three characteristics. The three characteristics TYP, MAX, MIN are the same as the characteristics TYP, MAX, MIN described in Fig. 6. Further, similar to Fig. 6, the horizontal axis of Fig. 11 represents the capacitance value of the variable capacitance circuit 307, while the vertical axis represents the delay time. The difference between Fig. 6 and Fig. 11 is that whether the capacitance value of the variable capacitance circuit 308 is changed and whether the capacitance value of the variable capacitance circuit 307 is changed.

Similar to Fig. 6, also in Fig. 11, when the capacitance value of the variable capacitance circuit 307 is increased, the delay time is also linearly increased. In other words, it is possible to indicate the capacitance value of the variable capacitance circuit 307 by the delay time, and to specify the capacitance value of the variable capacitance circuit 307 according to the delay time.

In Fig. 11, the delay time is the time interval from the rising of the measurement signal supplied to the external terminal X2 to when the voltage of the signal at the terminal T2 changes in response to this rise. However, the time (delay time) from the falling of the measurement signal supplied to the external terminal X2 to when the signal at the terminal T2 changes in response to this fall, also changes according to the characteristics similar to the characteristics shown in Fig. 11. In other words, in this case also, when the capacitance value of the variable capacitance circuit 307 is increased, the delay time is also linearly increased. Thus, also in the falling edge of the measurement signal supplied to the external terminal X2, it is possible to indicate the capacitance value of the variable capacitance circuit 307 by the delay time, and to specify the capacitance value according to the delay time.

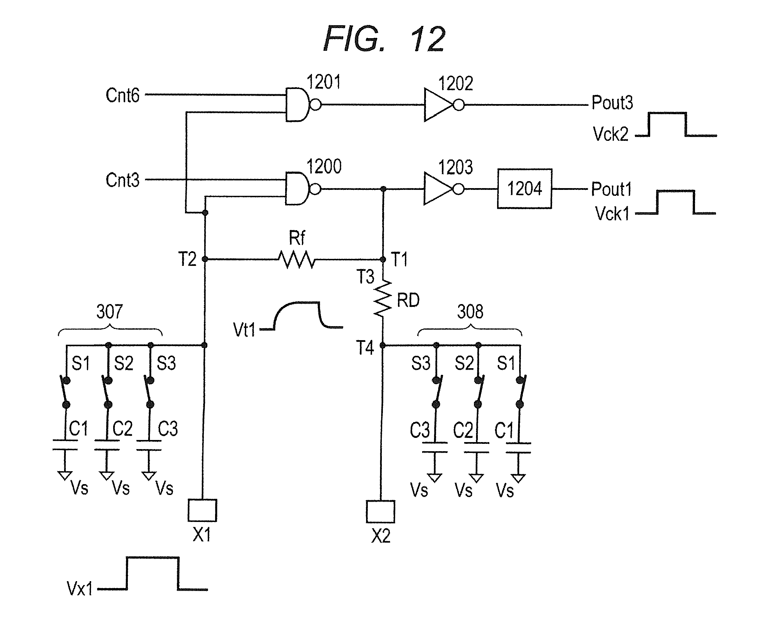

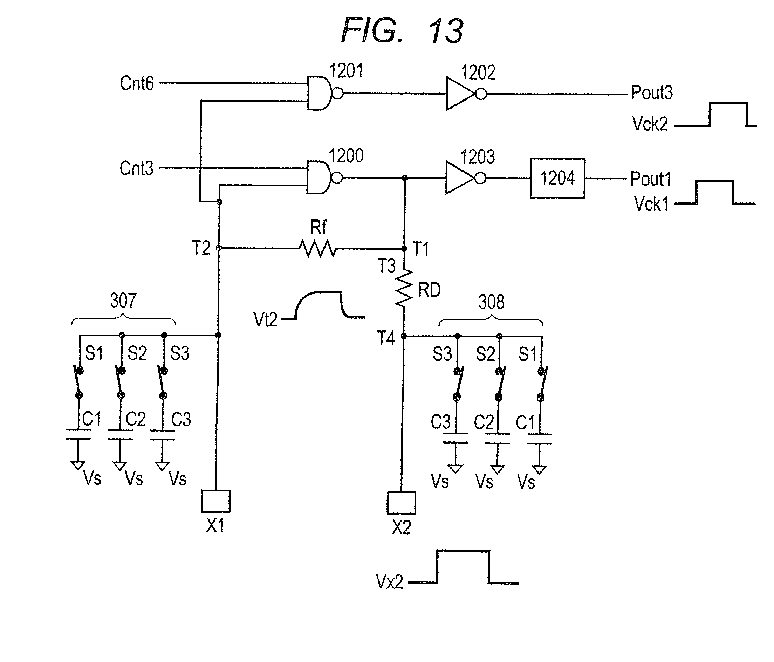

Figs. 12 and 13 are circuit diagrams showing the configuration of the main part of the semiconductor integrated circuit device 105 according to the third embodiment. Similar to Fig. 4, Figs. 12 and 13 show the main part of the oscillator circuit in the semiconductor integrated circuit device 105 shown in Fig. 3. In other words, Figs. 12 and 13 show the part corresponding to the inverter circuit 304, the feedback impedance element 305, the amplitude control impedance element 306, and the variable capacitance circuits 308 and 307, which are shown in Fig. 3. Figs. 12 and 13 show the configuration of the same circuit, in which Fig. 12 shows the operation of measuring the transmission delay time corresponding to the capacitance value of the combined capacitance combined with the external terminal X2 by supplying the measurement signal (Vx1) to the external terminal X1. While Fig. 13 shows the operation of measuring the delay time corresponding to the capacitance value of the combined capacitance combined with the external terminal X1 by supplying the measurement signal (Vx2) to the external terminal X2. In other words, with the configuration of the circuit shown in Figs. 12 and 13, it is possible to measure the delay time corresponding to the capacitance value of each of the external terminals X1 and X2 with which the external terminals of the crystal oscillator 107 are combined, respectively.

First, the configuration of the circuit shown in Figs. 12 and 13 will be described. In Fig. 4, the inverter circuit 304 is used as the negative resistance amplifier to perform oscillation. However, in Figs. 12 and 13, an NAND circuit 1200 with two inputs is used as a load resistance amplifier. One input of the NAND circuit 1200 is supplied with the activation signal Cnt3. The other input is coupled to the terminal T2 of the feedback resistive element Rf, and the output of the NAND circuit 1200 is coupled to the terminal T1 of the feedback resistive element Rf. The terminal T2 of the feedback resistive element Rf is coupled to the variable capacitance circuit 307 and the external terminal X1. Then, the terminal T1 is coupled to the terminal T3 of the amplitude control resistive element RD as well as the input of the inverter circuit 1203. The terminal T4 of the amplitude control resistive element RD is coupled to the variable capacitance circuit 308 and the external terminal X2. In other words, the terminal T1 of the feedback resistive element Rf is coupled to the external terminal X2 through the amplitude control resistive element RD, similarly to the first embodiment.

Further, the variable capacitance circuits 308 and 307 are the same as the variable capacitance circuits 308 and 307 in the configuration, respectively. In other words, in Figs. 12 and 13, the variable capacitance circuit 308 (307) has three series circuits coupled in parallel between the terminal T1 (T2) and the ground voltage Vs.

Here, the series circuit has switches S1 to S3 and capacitance elements C1 to C3, which are coupled in series to each other. The capacitance elements C1 to C3 have different capacitance values, respectively. Although not shown in Figs. 12 and 13, the switches S1 to S3 are switched and controlled by the capacitance value control signals sw1 and sw2 as shown in Fig. 4. Further, the output of an inverter circuit 1203 is coupled to the external terminal Pout1 through a buffer circuit 1204. Although not particularly limited, in the third embodiment, the buffer circuit 1204 inverts the phase of the supplied signal and output the inverted signal.

In the third embodiment, the two-input NAND circuit 1201 is added to form a signal path through which a measurement signal is transmitted when the measurement signal is supplied to the external terminal X2. In other words, one input of the two-input NAND circuit 1201 is coupled to the terminal T2 of the feedback resistive element Rf, and the other input is supplied with an activation signal Cnt6 from the control circuit 302 (Fig. 3).

When the value of the combined capacitance combined with the external terminal X1 or X2 is measured as the delay time, the control circuit 302 changes the activation signal Cnt3 to a low level and the activation signal Cnt6 to a high level. In this way, when the value of the combined capacitance combined with the external terminal X1 or X2 is measured as the delay time, the NAND circuit 1200 does not transit the signal at the terminal T2 to the terminal T1. On the other hand, at this time, the NAND circuit 1201 inverts the phase of the signal at the terminal T2 and outputs the inverted signal. The output of the NAND circuit is inverted in phase by the inverter circuit 1202 and is transmitted to the external terminal Pout3. Note that when the oscillation is performed, the control circuit 302 changes the activation signal Cnt3 to a high level and the activation signal Cnt6 to a low level. In this way, the NAND circuit 1200 inverts the phase of the signal at the terminal T2 and transmits to the terminal T1. At this time, the NAND circuit 1201 does not transmit the signal at the terminal T2 to the terminal T1 and, for example, supplies a high level to the input of the inverter circuit 1202.

Fig. 12 also shows the voltage waveform when the measurement signal (first measurement signal) is supplied to the external terminal X1 to measure the value of the combined value combined with the external terminal X2 as the transmission delay time. In Fig. 12, Vx1 represents the voltage of the measurement signal supplied to the external terminal X1, and Vt1 represents the voltage at the terminal T1 of the feedback resistive element Rf. Further, Vck1 represents the voltage of the signal (first observation signal) output from the external terminal Pout1, in response to a measurement signal when the measurement signal is supplied to the external terminal X1. Further, Vck2 represents the voltage of the signal (observation signal) output from the external terminal Pout3, similarly in response to the measurement signal.

Although not shown in Fig. 12, the external terminal X2 is coupled to the line of the substrate, and thus the parasitic capacitance Cp1 is coupled to the external terminal X2. When the measurement signal with the rectangular voltage Vx1 is supplied to the external terminal X1, the voltage Vt1 at the terminal T1 changes according to the time constant given by the feedback resistive element Rf, the variable capacitance circuit 308, and the parasitic capacitance Cp1 as described in the first embodiment. When the voltage Vt1 at the terminal T1 exceeds the predetermined threshold voltage VT, the voltage at the external terminal Pout1 changes to a high level (see Vck1). On the other hand, the high level of the measurement signal supplied to the external terminal X1 is transmitted to the terminal T2, and is supplied to the NAND circuit 1201. Then, the phase of the measurement signal is inverted by the NAND circuit 1201, which is further inverted by the NAND circuit 1202 and is transmitted to the external terminal Pout3. In this way, the voltage at the external terminal Pout3 changes as shown by the voltage Vck2.

As described above, the voltage at the terminal T1 changes according to the time constant given by the feedback resistive element Rf, the variable capacitance circuit 308, and the parasitic capacitance Cp1. Thus, as shown in Fig. 12, the time when the voltage at the external terminal Pout1 changes to high level is later than the time when the voltage at the external terminal Pout3 changes to high level. The time difference between the time when the voltage at the external terminal Pout3 changes to high level, and the time when the voltage at the external terminal Pout1 changes to high level is the delay time corresponding to the value of the combined capacitance combined with the external terminal X2. In other words, it is possible to measure the delay time corresponding to the value of the capacitance combined with the external terminal X2.

Fig. 13 also shows the voltage waveform when the measurement signal (second measurement signal) is supplied to the external terminal X2 to measure the value of the combined capacitance combined with the external terminal X1 as the transmission delay time. In Fig. 13, Vx2 represents the voltage of the measurement signal supplied to the external terminal X2 and Vt2 represents the voltage at the terminal T2 of the feedback resistive element Rf. Further, Vck1 represents the voltage of the signal (observation signal) output from the external terminal Pout1, in response to a measurement signal when the measurement signal is supplied to the external terminal X2. Further, Vck2 represents the voltage of the signal (second observation signal) output from the external terminal Pout3, similarly in response to the measurement signal.

Although also not shown in Fig. 13, the external terminal X1 is coupled to the line of the substrate, and thus the parasitic capacitance Cp2 is coupled to the external terminal X1. When the measurement signal (second measurement signal) with the rectangular voltage (Vx2) is supplied to the external terminal X2, the voltage Vt2 at the terminal T2 changes according to the time constant given by the feedback resistive element Rf, the capacitance of the variable capacitance circuit 307, and the parasitic capacitance Cp2. When the voltage Vt2 at the terminal T2 exceeds the threshold voltage (predetermined threshold voltage VT) of the NAND circuit 1201, the voltage at the external terminal Pout3 changes to a high level (see Vck2). On the other hand, the high level of the measurement signal supplied to the external terminal X2 is transmitted to the terminal T1, and is transmitted to the external terminal Pout1 through the inverter circuit 1203 and the buffer circuit 1204. In this way, the voltage at the external terminal Pout1 changes as shown by the voltage Vck1.

As described above, the voltage at the terminal T2 changes according to the time constant given by the feedback resistive element Rf, the variable capacitance circuit 307, and the parasitic capacitance Cp2. Thus, as shown in Fig. 12, the time when the voltage at the external terminal Pout3 changes to high level is later than the time when the voltage at the external terminal Pout1 changes to high level. The time difference between the time when the voltage at the external terminal Pout1 changes to high level, and the time when the voltage at the external terminal Pout3 changes to high level is the delay time corresponding to the value of the combined capacitance combined with the external terminal X1. In other words, it is possible to measure the delay time corresponding to the value of the capacitance combined with the external terminal X1.

For example, as described above, the semiconductor manufacturer measures the delay time corresponding to the capacitance combined with the external terminal X1 in the evaluation board, and presents the measured delay time to the electronic device manufacturer. Then, the electronic manufacturer sets the value of the register 301 so that the delay time in the board of the electronic device matches the delay time presented by the semiconductor manufacturer. In this way, it is possible to form a clock signal of a predetermined frequency also in the board of the electronic device.

<Variation 1>

The measurement signal generating circuit (inverter circuit 1000) described in Fig. 10 is provided in the semiconductor integrated circuit device 105 of the third embodiment. In this case, a selection circuit is provided to transmit the measurement signal generated by the measurement signal generating circuit, selectively to the terminal T1 or T2 of the feedback resistive element Rf. In this way, there is no need to supply the measurement signal to the external terminal X1 or X2.

Further, the switch SS1 described in Fig. 10 is provided between the terminal T2 and the external terminal X1 shown in Fig. 12 (Fig. 13), and the switch circuit SS2 is provided between the terminal T1 and the external terminal X2 shown in Fig. 12 (Fig. 13). In this way, it is possible to easily check the capacitance value of each of the variable capacitance elements 308 and 307.

<Variation 2>

In Figs. 12 and 13, when the measurement signal (second measurement signal) is supplied to the external terminal X2, a high level activation signal Cnt6 is supplied to the NAND circuit 1201. When the measurement signal (first measurement signal) is supplied to the external terminal X1, a low level activation signal Cnt6 is supplied to the NAND circuit 1201. In this way, the signal that changes according to the time constant given by the feedback resistive element Rf, the variable capacitance circuit 307, and the parasitic capacitance Cp2, is transmitted to the external terminal Pout3 through the NAND circuit 1201. On the other hand, the signal that changes according to the time constant given by the feedback resistive element Rf, the variable capacitance circuit 308, and the parasitic capacitance Cp1, is transmitted to the external terminal Pout1 through the inverter 1203.

In this case, the time difference between the measurement signal (second measurement signal) supplied to the external terminal X2 and the signal output from the external terminal Pout3 is measured as the delay time corresponding to the value of the capacitance combined with the external terminal X1. Similarly, the time difference between the measurement signal (first measurement signal) supplied to the external terminal X1 and the signal output from the external terminal Pout1 is measured as the delay time corresponding to the value of the capacitance combined with the external terminal X2.

Fourth Embodiment

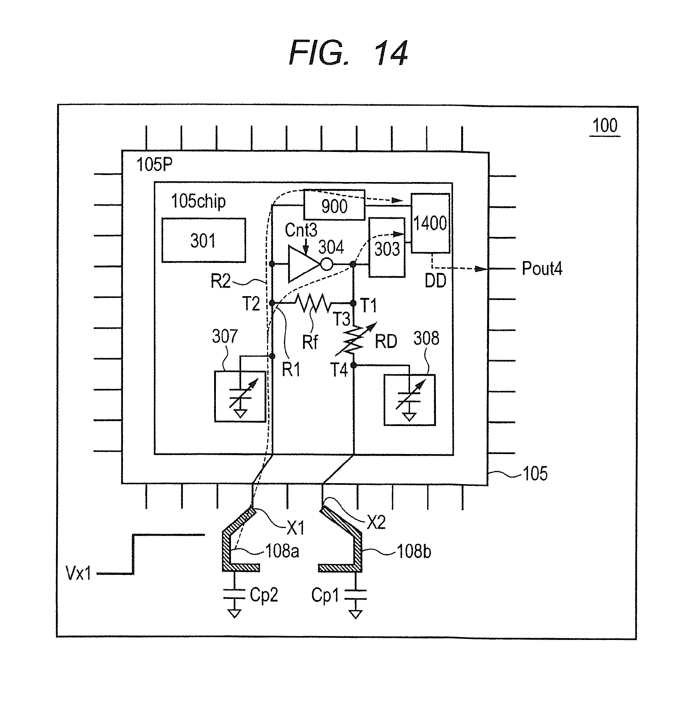

Fig. 14 is a block diagram showing the configuration of a board according to a fourth embodiment. The configuration of the board shown in Fig. 14 is similar to the configuration shown in Fig. 9. Here, the description mainly focuses on the difference from Fig. 9.

Different from the configuration of the semiconductor integrated circuit device 105 shown in Fig. 9, in the fourth embodiment, a measurement circuit 1400 is provided in the semiconductor integrated circuit device 105 to measure the time difference between the output from the buffer circuit 900 and the output from the buffer circuit 303. In other words, the measurement circuit 1400 is formed in the semiconductor chip 105chip. The measurement circuit 1400 measures the time difference, for example, between the time when the signal output from the buffer circuit 900 changes to high level and when the signal output from the buffer circuit 303 changes to high level. Then, the measurement circuit 1400 transmits the measured time difference to the external terminal Pout4 as delay time information DD.

The semiconductor manufacturer obtains the delay time information DD and presents to the electronic device manufacturer. Then, the electronic device manufacturer sets the value of the register 301 so that the delay time corresponds to the presented delay time information DD in the board to be mounted in the electronic device.

In the semiconductor integrated circuit device 105 shown in Fig. 9, the observation signal according to the measurement signal supplied to the external terminal X1 is transmitted to the external terminals Pout1 and Pout2 separately through the two signal transmission paths R1 and R2. The change in the voltage in each of the external terminals Pout1 and Pout2 varies depending on the parasitic capacitance associated with each of the external terminals Pout1 and Pout2. Thus, it may be difficult to measure the delay time corresponding to the value of the combined capacitance combined with the external terminal X2 if there is a difference in the capacitance value of the parasitic capacitance associated with each of the external terminals Pout1 and Pout2.

On the other hand, in the semiconductor integrated circuit device 105 shown in Fig. 14, the time difference between the observation signals transmitted through the two signal paths is measured and output as the delay time information DD within the semiconductor integrated circuit device 105. Thus, it is possible to obtain the correct delay time even if the capacitance value of the parasitic capacitance is different between the external terminals (Pout1, Pout2).

Of course, as described in the third embodiment, it is possible to output the delay time information DD corresponding to the value of the combined capacitance combined with each of the external terminal X1 and X2, from the external terminal Pout4. Next, a configuration example of the measurement circuit 1400 will be described. The configuration example of the measurement circuit 1400 described below is an example of outputting the delay time information DD corresponding to the value of the combined capacitance combined with each of the external terminals X1 and X2.

<Measurement circuit 1>

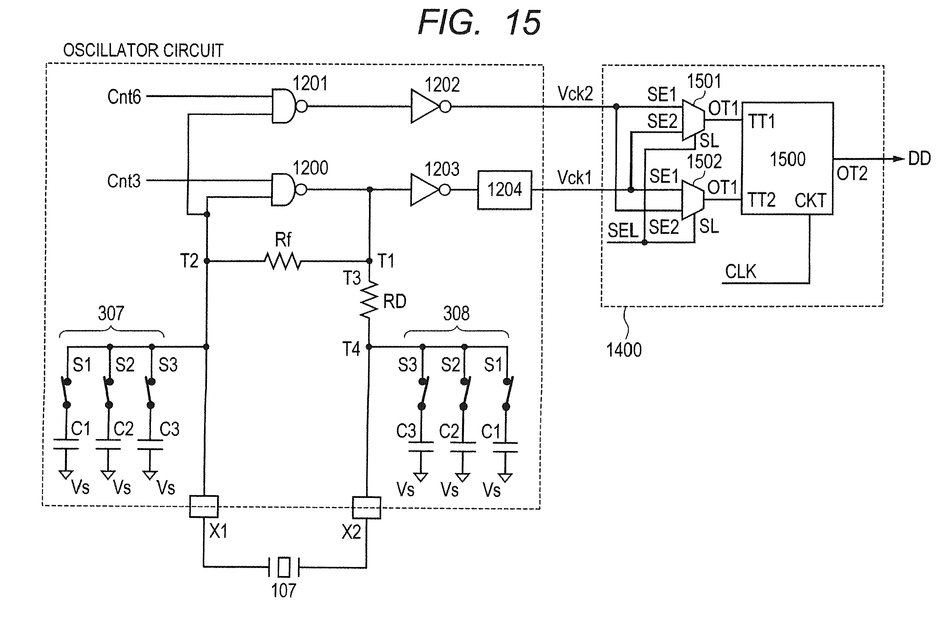

Fig. 15 is a block diagram showing an example of the measurement circuit 1400 described above. In Fig. 15 it is also shown the configuration of the oscillator circuit. The configuration of the oscillator circuit is the same as Figs. 12 and 13, so that the description thereof will be omitted here. Note that Fig. 15 shows the state in which the external terminals of the crystal oscillator 107 are coupled to the external terminal X1 and the external terminal X2, respectively, to clarify that is it the oscillator circuit.

The measurement circuit 1400 includes a counter circuit 1500 and selectors 1501 and 1502. Each of the selectors 1501 and 1502 includes two input terminals SE1 and SE2, a selection instruction terminal SL, and an output terminal OT1. Each of the selectors selects the input terminal, either SE1 or SE2, according to the voltage of a selection signal SEL supplied to the selection instruction terminal SL, and couples the selected input terminal to an output terminal OT1.

Further, the counter circuit 1500 includes two input terminals TT1 and TT2, a clock terminal CKT, and an output terminal OT2. When a predetermined voltage (for example, high level) is supplied to the input terminal TT1, the counter circuit 1500 starts a count operation to count the clock signal supplied to the clock terminal CKT. Then, the counter circuit 1500 stops the count operation when the predetermined voltage (high level) is supplied to the input terminal TT2. The counter circuit 1500 outputs the value counted by the count operation as the delay time information DD.

In the measurement circuit 1400, the input terminal SE1 of the selector 1501 is coupled to the output of the inverter circuit 1202, and the input terminal SE2 of the selector 1501 is coupled to the output of the buffer circuit 1204. Further, the input terminal SE1 of the selector 1502 is coupled to the output of the buffer circuit 1204, and the input terminal SE2 of the selector 1502 is coupled to the output of the inverter circuit 1202. The selection signal SEL is commonly supplied to the selection instruction terminal SL of the selector 1501 and to the selection instruction terminal SL of the selector 1502. Each of the selectors 1501 and 1502 couples the input terminal SE1 to the output terminal OT1 when the selection signal SEL is at a high level, and the input terminal SE2 to the output terminal OT1 when the selection signal SEL is at a low level.

As shown in Figs. 12 and 13, when the measurement signal is supplied to the external terminal X1 or X2, the voltage Vck2 that changes as shown in Figs. 12 and 13 is output from the inverter circuit 1202, and the voltage Vck1 that changes as shown in Figs. 12 and 13 is output from the buffer circuit 1204. Further, as shown in Figs. 12 and 13, when the measurement signal (first measurement signal) is supplied to the external terminal X1, the voltage Vck2 rises before the rise of the voltage Vck1. On the other hand, when the measurement signal (second measurement signal) is supplied to the external terminal X2, the voltage Vck1 rises before the rise of the voltage Vck2.

Although not particularly limited, the selection signal SEL and the clock signal CLK are formed by the control circuit 302. When the measurement signal is supplied to the external terminal X1, the control circuit 302 changes the selection signal SEL to a high level. On the other hand, when the measurement signal is supplied to the external terminal X2, the control circuit 302 changes the selection signal SEL to a low level. In this way, when the measurement signal is supplied to the external terminal X1, each of the selectors 1501 and 1502 couples the input terminal SE1 to the output terminal OT1. As a result, when the measurement signal is supplied to the external terminal X1, the output of the inverter circuit 1202 is coupled to the input terminal TT1 of the counter circuit 1500 through the selector 1501. Then, the output of the buffer circuit 1204 is coupled to the input terminal TT2 of the counter circuit 1500 through the selector 1502.

In this way, the voltage Vck2 in which the high level rises earlier is supplied to the input terminal TT1 of the counter circuit 1500, and the voltage Vck1 in which the high level rises later is supplied to the input terminal TT2. During this time, the counter circuit 1500 performs the count operation of the clock signal CLK. The time difference between the voltage Vck2 and the voltage Vck1 corresponds to the capacitance value of the combined capacitance combined with the external terminal X2. Thus, the value counted by the count operation in the counter circuit 1500 is the delay time corresponding to the value of the combined capacitance. In other words, the counter circuit 1500 outputs the delay time information DD that shows the delay time corresponding to the capacitance value of the combined capacitance combined with the external terminal X2.

When the measurement signal (second measurement signal) is supplied to the external terminal X2, the selection signal SEL of a low level is output from the control circuit 302. In this way, the selector 1501 transmits the voltage Vck1 from the buffer circuit 1204 to the input terminal TT1 of the counter circuit 1500. Then, the selector 1502 transmits the voltage Vck2 from the inverter 1202 to the input terminal TT2 of the counter circuit 1500. As shown in Fig. 13, when the measurement signal is supplied to the external terminal X2, the voltage Vck1 output from the buffer circuit 1204 rises to a high level before the rise of the voltage Vck2 output from the inverter circuit 1202. Along with this, the input terminals TT1 and TT2 are selected by the selectors 1501 and 1502, respectively, so that the voltage Vck1 is supplied to the input terminal TT1 of the counter circuit 1500 and the voltage Vck2 is supplied to the input terminal TT2 of the counter circuit 1500. In this way, similar to the case of supplying the measurement signal to the external terminal X1, the counter circuit 1500 counts the clock signal CLK and outputs the counted value as the delay time information DD during the time corresponding to the delay time.

It is possible to form the measurement circuit by a relatively simple configuration, and to prevent an increase in the area of the semiconductor chip of the semiconductor integrated circuit device 105.

<Measurement circuit 2>

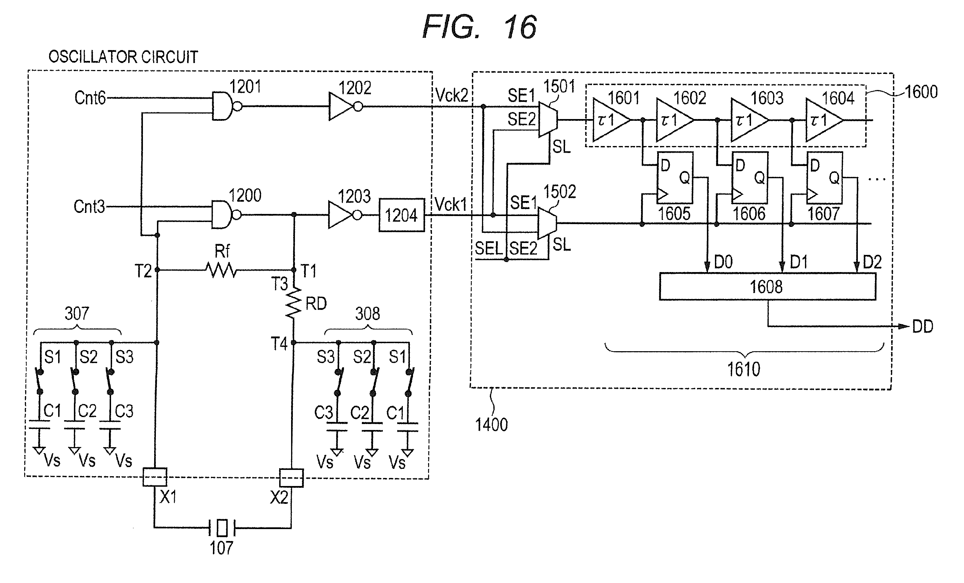

Fig. 16 is a block diagram of another configuration of the measurement circuit 1400. Also in Fig. 16, the measurement circuit 1400 and the oscillator circuit are shown. The configuration of the oscillator circuit shown in Fig. 16 is the same as the configuration of the oscillator circuit shown in Fig. 15, so that the description thereof will be omitted here. The measurement circuit 1400 shown in Fig. 16 includes the selectors 1501 and 1502 descried in Fig. 15, and a time-digital conversion circuit 1610. The configuration and operation of the selectors 1501 and 1502 is the same as in Fig. 15, so that the detailed description is omitted here. Even when the measurement signal is supplied to either external terminal X1 or X2, the voltage rising earlier is output from the selector 1501 and the voltage rising later is output from the selector 1502. The time difference between these rises corresponds to the capacitance value of the combined capacitance combined with the external terminal.

The time-digital conversion circuit 1610 includes a delay line 1600, a plurality of flip-flops (hereinafter referred to as FF) that receive a plurality of delay signals delayed by the delay line 1600, and an encoder circuit 1608 for encoding the output from the FF circuits. In Fig. 16, the delay line 1600 is configured by a plurality of delay circuits coupled in series. Of the delay circuits, delay circuits 1601 to 1604 are shown as representatives in the figure. Further, of the FF circuits, FF circuits 1605 to 1607 that receive the outputs of the delay circuits 1601 to 1603 are shown as representatives in the figure. Also, only the part of the encoder circuit that encodes the outputs of the FF circuits 1605 to 1607 is shown in the figure.

The voltage output from the selector 1501 is supplied to the delay line 1600, and is sequentially delayed by each of the delay circuits 1601 to 1604. The delay signal delayed by the delay line 1600 is supplied to data input terminals D of the FF circuits 1605 to 1607. Each of the FF circuits 1605 to 1607, in which the output from the selector 1502 is supplied to a trigger terminal thereof, latches the binary signal according to the voltage supplied to the data input terminal D, at the time when the output from the selector 1502 supplied to the trigger terminal rises to a high level. In Fig. 16, the binary signals of the FF circuits 1605 to 1607 are shown as data D0 to D2. The data D0 to D0, and so on, are encoded by the encoder 1608, and are output as the delay time information (digital signal) DD.

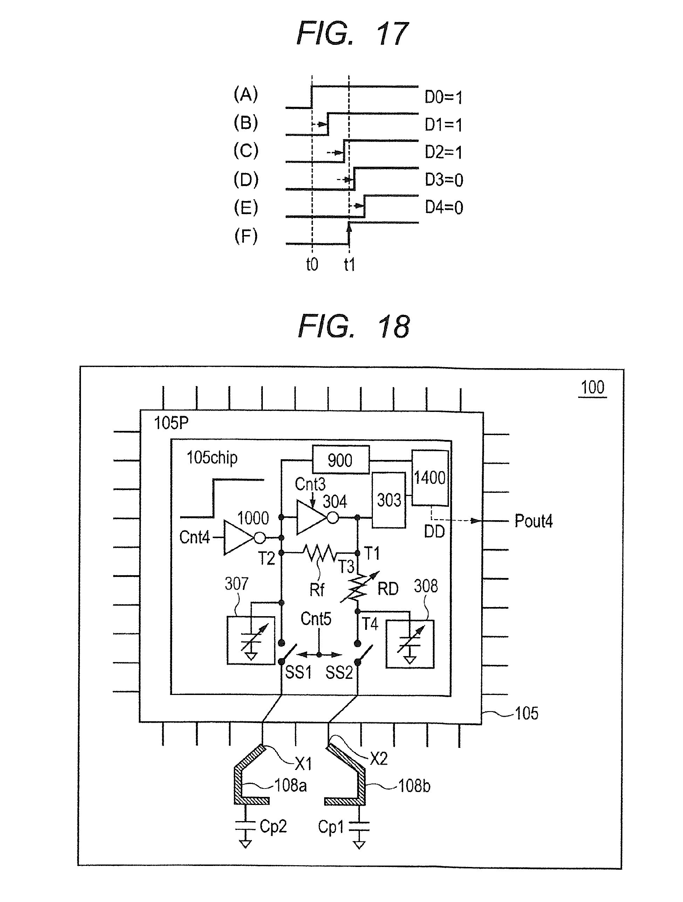

Figs. 17A to 17F are timing diagrams showing the operation of the time-digital conversion circuit 1601 shown in Fig. 16. The operation of the time-digital conversion circuit 1601 will be described with reference to Figs. 17A to 17F. The output of the selector 1501 rises to a high level, and then the output of the delay circuit 1601 changes to a high level with a delay by the delay time of the delay time circuit 1601. Due to the change to the high level, the output of the FF circuit 1605 changes to a high level. As a result, the data D0 is equal to 1 (Fig. 17A). Next, the output of the delay circuit 1602 changes to a high level with a delay by the delay time of the delay circuit 1602. The output of the FF circuit 1606 changes to a high level, and as a result, the data D1 is equal to 1 (Fig. 17B).

After that, the outputs of the delay circuits 1603 and so on sequentially change to a high level. The outputs of the FF circuits 1607 and so on sequentially change to a high level. As a result, the data D2 is equal to 1 and so on (Figs. 17C to 17E). At the delay time corresponding to the capacitance value of the combined capacitance combined with the external terminal X1 or X2, the output of the selector 1502 changes to a high level (Fig. 17F). Due to the change to the high level, each FF circuit latches the state at this time. In Figs. 17A to 17F, the FF circuits 1605 to 1607 output a high level, and the FF circuit 1607 and subsequent FF circuits output a low level. In this way, a binary signal "1" is supplied to D0 to D2, and a binary signal "0" is supplied to D3 and subsequent data in the encoder circuit. In other words, the time from t0 to t1 is output as the delay time information DD of the digital signals.

As described above, the delay time can be obtained as the digital signal in any of the measurement circuit. Thus, it is possible to easily understand the measured value.

Further, since the measurement circuit 2 is configured to encode by the encoder circuit, it is possible to reduce the number of digital signals of the delay time information DD. As a result, it is possible to improve the convenience in presenting the delay time information DD.

<Variation>

Fig. 18 is a block diagram showing a variation of the semiconductor integrated circuit device 105. The difference from Fig. 14 is that the measurement signal generating circuit (inverter circuit 1000) described in Fig. 10, as well as the switch circuits SS1 and SS2 are added. In Fig. 18, instead of the measurement signal supplied to the external terminal X1, a measurement signal is formed by the measurement signal generating circuit (inverter circuit 1000) and is supplied to the terminal T2. In this way, it is possible to measure the delay time corresponding to the capacitance value of the capacitance combined with the external terminal X2 by the measurement circuit 1400, without supplying the measurement signal to the external terminal X1, and to output the measured delay time, for example, from the external terminal Pout4 as the delay time information DD.

Further, the measurement signal formed by the measurement signal generating circuit (inverter 1000) is supplied to the terminal T2 or the terminal T1 by the selection circuit not shown. In this way, it is possible to output the delay time information DD corresponding to the value of the capacitance combined with the external terminal X1, as well as the delay time information DD corresponding to the value of the capacitance combined with the external terminal X2, from the external terminal Pout4 by the measurement circuit 1400, without supplying the measurement signal to the external terminals X1 and X2.

In the variation, similar to Fig. 10, the switch circuits SS1 and SS2 are provided. Thus, when the semiconductor integrated circuit device 105 is tested, the switch circuits SS1 and SS2 are put into an OFF state to supply the measurement signal formed by the measurement signal generating circuit, to the terminal T2 or T1. In this way, it is possible to check the capacitance value of each of the variable capacitance circuits 307 and 308 by the delay time information DD. In particular, in this variation, there is no need to measure the signal between the external terminals (for example, Pout1 and Pout2 in Fig. 10), so that the test can easily be performed.

Fifth Embodiment

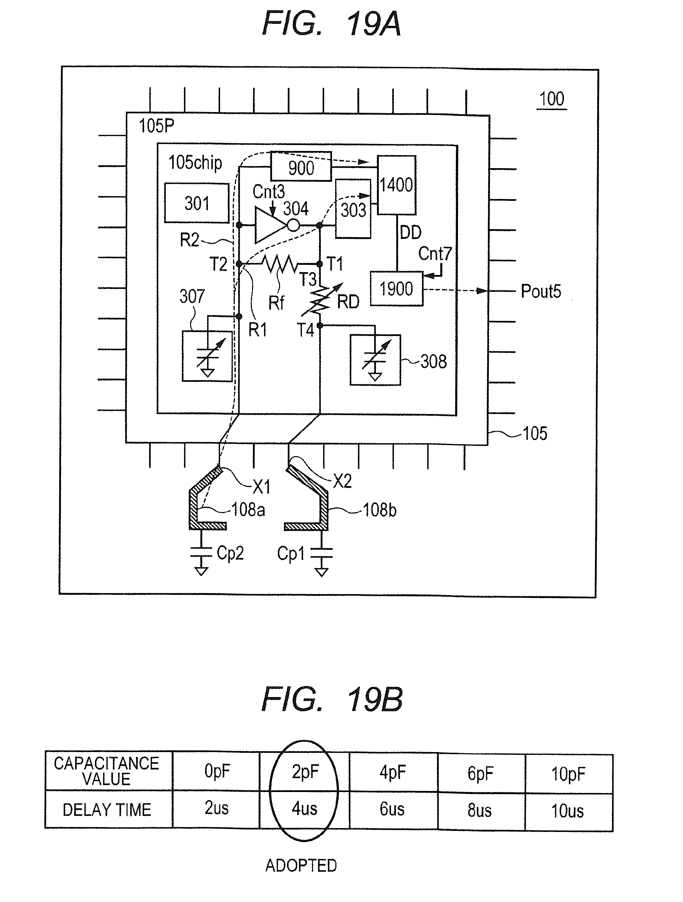

Figs. 19A and 19B are schematic diagrams showing a board according to a fifth embodiment. Here, Fig. 19A is a block diagram showing the configuration of a board, and Fig. 19B is a table diagram showing the measurement in the electronic device manufacturer. The board shown in Fig. 19A is similar to the board shown in Fig. 14. The description mainly focuses on the difference from the board shown in Fig. 14.

In the board shown in Fig. 14, the measurement circuit 1400 is formed in the semiconductor chip 105chip in which the delay time information DD is transmitted from the measurement circuit 1400 to the external terminal Pout4. On the other hand, an electrically rewritable nonvolatile memory 1900 is also formed in the semiconductor chip 105chip shown in Fig. 19. In this embodiment, a flash memory is used as the rewritable nonvolatile memory (hereinafter simply referred to as the storage circuit), but the present invention is not particularly limited to this.

In the storage circuit 1900, the reading and wiring is controlled by a read/write control signal Cnt7 from the control circuit 302 (Fig. 3). Also in the fifth embodiment, as described in Figs. 14 to 16, the delay time information DD corresponding to the value of the capacitance combined with each of the external terminals X1 and X2 is formed by the measurement circuit 1400. The formed delay time information DD is supplied to the storage circuit 1900. The control circuit 302 instructs the storage circuit 1900 to perform a write operation by the read/write control signal Cnt7 at the timing when the delay time information DD is supplied to the storage circuit 1900. In this way, the delay time information DD formed by the measurement circuit 1400 is written in the storage circuit 1900. The written delay time information DD is output from the external terminal Pout5, at the time when the read/write control signal Cnt7 from the control circuit 302 instructs a read operation.

According to the fifth embodiment, the presentation of the delay time information DD can be not only reliably performed but also facilitated. In other words, when the delay time information DD is formed by the measurement circuit 1400, the formed delay time information DD is written in the storage circuit 1900 in which the semiconductor chip 105chip, which is the same as the measurement circuit 1400, is formed. Thus, the delay time information DD and the semiconductor chip 105chip correspond to each other one to one. In other words, the semiconductor integrated circuit device 105 and the delay time information DD correspond to each other one to one. Thus, when a semiconductor circuit device is provided, the delay time information of the semiconductor integrated circuit can be reliably provided. Further, as for the presentation, it is possible to present the delay time information DD without using paper or other print media. Thus, easy presentation can be achieved.

Next, a description will be given to the presentation of the delay time information DD as well as the setting using the presented delay time information DD. Here, it is assumed that the semiconductor manufacturer that provides the semiconductor integrated circuit device presents the delay time information DD, and that the electronic device manufacturer performs setting in the board to be attached to the electronic device by using the presented delay time information DD.

First, as described in Figs. 14 to 16, the semiconductor manufacturer measures the delay time information DD corresponding to the value of the capacitance combined with each of the external terminals X1 and X2, and writes the delay time information DD into the storage circuit 1900. Next, the semiconductor manufacturer provides the semiconductor integrated circuit device 105 with the written delay time information DD, to the electronic device manufacturer. Here, when measuring the delay time information DD by the measurement circuit 1400, the semiconductor manufacturer mounts the semiconductor integrated circuit device 105 to the evaluation board unique to the semiconductor manufacturer. Further, the semiconductor manufacturer also mounts the crystal oscillator 107 and the like to the evaluation board. Then, the semiconductor manufacturer sets the value of the variable capacitance circuits 308 and 307 when a clock signal of a predetermined frequency is formed, and measures the delay time information DD. It is assumed that the delay time information DD at this time is, for example, 4.2 us with respect to each of the external terminals X1 and X2. In this case, the semiconductor integrated circuit device 105, in which the delay time information DD showing 4.2 us is written in the storage circuit 1900, is provided to the electronic device manufacturer.

When provided with the semiconductor integrated circuit device 105, the electronic device manufacturer mounts the semiconductor integrated circuit device 105 to the substrate of the board included in the electronic device to be produced. In this case, the substrate 100 and/or the wiring pattern is generally different in the board included in the electronic device and the evaluation board in the semiconductor manufacturer. For this reason, when the semiconductor integrated circuit device 105 is mounted in the substrate of the board included in the electronic device, the value of the parasitic capacitance associated with each of the external terminals X1 and X2 of the semiconductor integrated circuit device 105 is different from the value when it is mounted in the evaluation board. Thus, a clock signal of a desired frequency may not be formed, even if the variable capacitance circuits 308 and 307 are set to the same value as the value when the semiconductor integrated circuit device 105 is mounted in the evaluation board.

Thus, the electronic device manufacturer mounts the semiconductor integrated circuit device 105 to the board that is provided in the electronic device. Then, the electronic device manufacturer supplies the measurement signal to the external terminals X1 and X2, with the semiconductor integrated circuit device 105 mounted, to perform the measurement operation described, for example, in Figs. 14 to 16. In this measurement operation, the electronic device manufacturer collects the delay time information DD by changing the value of the register 301. In other words, the capacitance value of each of the variable capacitance circuits 308 and 307 is changed due to the change in the value of the register 301, so that the electronic device manufacturer collects the delay time information corresponding to each capacitance value. Fig. 19B is a table showing the correspondence between the delay time information DD that the electronic device manufacturer collected, and the capacitance value of each of the variable capacitance circuits 308 and 307.

The table shown in Fig. 19B shows the capacitance value of the variable capacitance circuit, and the delay time shown by the delay time information DD at the time of the change to the particular capacitance value. For example, the table shows that when the capacitance value of the variable capacitance circuit 308 is changed to 0 pF, the delay time shown by the delay time information DD obtained by the measurement circuit 1400 is 2 us. Similarly, it shows that when the capacitance value is changed to 2 pF, the delay time shown by the delay time information DD is 4 us.

The electronic device manufacturer reads the delay time information DD written in the storage circuit 1900 of the semiconductor integrated circuit device 105. Then, the electronic device manufacturer selects the capacitance value of the variable capacitance circuit 308 corresponding to the delay time, which is the same or close to the delay time shown by the read delay time information DD, from the table shown in Fig. 19. Then, the electronic device manufacturer fixes the value of the register 301 so that the register 301 continuously specifies the selected capacitance value. The fixing is performed, for example, by the control circuit 302 by inhibiting writing to the register 301, after the value of specifying the selected capacitance value is set to the register 301. The electronic device manufacturer performs the same operation on the variable capacitance circuit 307 so that the variable capacitance circuit 307 has the selected capacitance value.

In the example of Fig. 19B, the delay time shown by the delay time information DD presented by the semiconductor manufacture is 4.2 us. Thus, the capacitance value 2 pF corresponding to the 4 us close to 4.2 us is selected and adopted. Then, the electronic device manufacturer sets and fixes the value of the register 301 so that the capacitance value of each of the variable capacitance circuits 308 and 307 is 2 pF.

The delay time information DD shows the delay time corresponding to the capacitance combined with the external terminal X1 and X2, namely, the combined capacitance including the parasitic capacitance (including the parasitic capacitance of the lines) associated with the external terminals X1 and X2. Thus, even when the board to be attached to the electronic device is different from the evaluation board, it is possible to equally set the value of the combined capacitance combined with the external terminals X1 and X2. Thus, it is possible to form a clock signal of a predetermined (desired) frequency in the board to be attached to the electronic device.

Further, even when the electronic device manufacturer changes the substrate of the board and/or the wiring pattern, it is possible to form a clock signal of a desired frequency in the changed board by performing the operation described above on the changed board. Thus, it is possible to eliminate the need to provide the board, and the like, to request the crystal oscillator manufacturer to obtain the appropriate capacitance value. As a result, it is possible to reduce the delay in the production of the electronic device.

Further, as shown in Figs. 6 and 11, the relationship between the delay time and the capacitance value is linear. Thus, by selecting (adopting) the capacitance value corresponding to the delay time close to the delay time shown by the presented delay time information DD, it is possible to form a clock signal of a frequency that is closer to the desired frequency.

<First Variation>

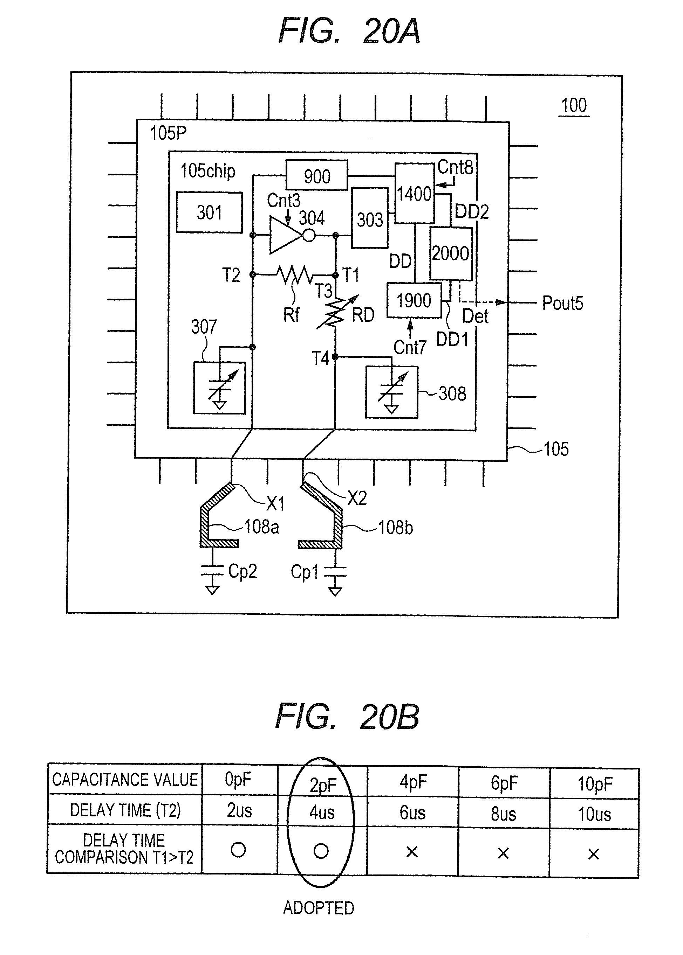

Figs. 20A and 20B are schematic diagrams showing the board according to a first variation of the fifth embodiment. Here, Fig. 20A is a block diagram showing the configuration of the board, and Fig. 20B is a table diagram showing the measurement in the electronic device manufacturer. The board shown in Fig. 20A is similar to the board shown in Fig. 19A. The description mainly focuses on the difference from the board shown in Fig. 19A.

In Fig. 19A, the storage circuit 1900 is formed in the semiconductor chip 105chip to store the delay time information DD obtained by the measurement circuit 1400. In the first variation, a comparator circuit 2000 is also formed in the semiconductor chip 105chip to compare the delay time information, which is obtained by the measurement circuit 1400, with the delay time information stored in the storage circuit 1900. Although not particularly limited, the comparative circuit 2000 transmits the result of the comparison to the external terminal Pout5, and outputs it to the outside of the semiconductor integrated circuit device 105.

The semiconductor manufacturer performs the same process as the process described in Figs. 19A and 19B. More specifically, the semiconductor manufacturer performs the steps of measuring the delay time by the measurement circuit 1400, writing the measured delay time information DD into the storage circuit 1900, and providing the semiconductor integrated circuit device 105 to the electronic device manufacturer.

In the first variation, an output destination control signal Cnt8 is formed in the control circuit 302 (Fig. 3) to determine whether the delay time information formed by the measurement circuit 1400 is transmitted to the storage circuit 1900 or the comparator circuit 2000. When the delay time is measured in the semiconductor manufacturer, the control circuit 302 forms the output destination control signal Cnt8 to instruct to transmit the delay time information formed by the measurement circuit 1400 to the storage circuit as the delay time information DD. While when the delay time is measured in the electronic device manufacturer, the control circuit 302 forms the output destination control signal Cnt8 to instruct to transmit the delay time information formed by the measurement circuit 1400 to the comparator circuit 2000 as delay time information DD2.

For example, the semiconductor manufacturer writes the delay time information DD into the storage circuit 1900. Then, the semiconductor manufacturer configures the control circuit 302 to form the output destination control signal Cnt8 so that the delay time information is transmitted to be used only as the delay time information DD2. In this way, it is also possible to prevent the delay time information from being written in the storage 1900 by mistake in the electronic device manufacturer.

Further in the first variation, the control circuit 302 forms the read/write control signal Cnt7 as a read instruction when the measurement is performed in the electronic device manufacturer.

When provided with the semiconductor integrated circuit device 105, the electronic device manufacturer mounts the semiconductor integrated circuit device 105 to the board to be attached to the electronic device. The electronic device manufacture supplies the measurement signal to each of the external terminals X1 and X2 with the semiconductor integrated circuit device 105 being mounted. Then, the electronic device manufacturer measures the delay time by the measurement circuit 1400. The measurement is performed by changing the value of the register 301. In this way, the measurement is performed by also changing the capacitance value of the variable capacitance circuits 308 and 307. The delay time information formed by the measurement is supplied to the comparator circuit 2000 as the delay time information DD2. In the measurement in the electronic device manufacturer, the delay time information stored in the storage circuit 1900 is read as delay time information DD1 by the read/write control signal from the control circuit 302, and the delay time information DD1 is supplied to the comparator circuit 2000.

The comparator circuit 2000 compares the supplied delay time information DD1 with the delay time information DD2, and transmits the result of the comparison to the external terminal Pout5. The comparison in the comparator circuit 2000 is performed to determine, for example, whether the delay time shown by the delay time information DD1 supplied from the storage circuit 1900 is longer or shorter than the delay time shown by the delay time information DD2 supplied form the measurement circuit 1400.

Fig. 20B is a table showing the results of the measurement in the electronic device manufacturer. In this table, the capacitance value of the variable capacitance circuits 308 and 307 that is changed in the measurement is shown in the top row, and the delay time (T2) shown by the delay time information DD2 is shown in the middle row. Then, a result Det (described as delay time comparison in the figure) is shown in the bottom row. The result Det is transmitted to the external terminal Pout5 from the comparator circuit 2000. Here, in the comparison result Det, a circular mark is placed when the delay time (T1), which is represented by the delay time information DD the semiconductor manufacturer has written in the storage circuit 1900, is longer than the delay time (T2), while a cross mark is placed when the delay time (T1) is shorter than the delay time (T2). In this example, the measurement of the semiconductor manufacturer determines that the delay time appropriate to form the clock signal of desired frequency is 4.5 us. In other words, the appropriate delay time is 4.2 us in Fig. 19, but in this example, 4.5 us is measured as the appropriate delay time.

From the table of Fig. 20B, it can be found that circular marks are placed in the comparison result Det when the capacitance value of the variable capacitance circuits 308 and 307 is 0 pF and 2 pF, and cross marks are placed in the comparison result Det when the capacitance value exceeds 4 pF. As a result, it is determined that a value between 2 pF and 3 pF is appropriate for the capacitance value of the variable capacitance circuits 308 and 307. The relationship between the capacitance and the delay time is linear as described above. Thus, here the value of the register 301 is set so that the capacitance value of each of the variable capacitance circuit 308 and 307 is set to the capacitance value 2 pF corresponding to 4 us, which is close to the delay time 4.5 us shown by the delay time information DD presented by the semiconductor manufacturer, which is the target for ensuring the consistency between the delay times.

In this way, even when the evaluation board and the customer board are different in the substrate and/or the wiring pattern, it is possible to form the clock signal of desired frequency in the customer board.

According to this variation, it is possible to set the capacitance value of each of of the capacitance variable circuits 308 and 307 by the result of the comparison. Thus, the burden on the electronic device manufacturer can be reduced.

<Second Variation>

A volatile storage circuit is also formed in the semiconductor chip 105chip shown in Fig. 20A to store a table similar to the table shown in Fig. 20B. In the table stored in the volatile storage circuit, the item of the capacitance value in Fig. 20B represents the value of the register 301. In the second variation, a detection circuit is also formed in the volatile storage circuit to detect the change from the circle mark to the cross mark in the observation result Det. When the change from the circle mark to the cross mark is detected by the detection circuit, the value of the register 301 corresponding to the circle mark or the value of the register 301 corresponding to the cross mark is set to the register 301 by the control circuit 302.

According to the second variation, there is no need to set the value of the registers 308 and 307 based on the comparison result Det output from the external terminal Pout5 of the semiconductor integrated circuit device 105. As a result, it is possible to further reduce the burden on the electronic device manufacturer.

The fourth and fifth embodiments described above are examples in which the electronic device manufacturer supplies the measurement signal to the external terminals X1 and X2 of the semiconductor integrated circuit device 105 mounted in the customer board. However, for example, as shown in Fig. 18, it may also be possible to provide the measurement signal generating circuit in the semiconductor integrated circuit device 105. In this way, the electronic device manufacturer can save the need to supply the measurement signal to the semiconductor integrated circuit device 105 mounted in the customer board, thus making it more convenient and simpler than conventional methods. Note that the detection circuit for detecting the change from the circle mark to the cross mark can easily be achieved using an exclusive logical sum circuit and the like.

Although the invention made by the present inventors has been specifically described based on the embodiments, the present invention is not limited to the specific embodiments, and various changes and modifications can be made without departing from the scope of the present invention. For example, in the foregoing embodiments, the capacitance value of the variable capacitance circuits 308 and 307 is set by the register 301. However, it is also possible to set the resistance value of the variable amplitude control resistive element, in addition to the capacitance value.

**Claims**

1. A semiconductor integrated circuit device having a function to perform oscillation in combination with a crystal oscillator having a pair of terminals, wherein the semiconductor integrated circuit device comprises:

    a first external terminal to which one of the pair of terminals of the crystal oscillator is coupled when the oscillation is performed; a second external terminal to which the other one of the pair of terminals of the crystal oscillator is coupled when the oscillation is performed;

a feedback impedance element including a first terminal coupled to the first external terminal as well as a second terminal coupled to the second external terminal when the oscillation is performed;

a first variable capacitance circuit coupled to the first terminal of the feedback impedance element; and

a configuration circuit for setting a capacitance value of the first variable capacitance circuit, wherein a first measurement signal is supplied to the second terminal of the feedback impedance element,

wherein, in response to the supply of the first measurement signal, a capacitance value of the first variable capacitance circuit is set by the configuration circuit based on the delay time with respect to the first measurement signal of a first observation signal generated at the first terminal of the feedback impedance element.

2. A semiconductor integrated circuit device according to claim 1,

wherein the semiconductor integrated circuit device comprises:

an active circuit coupled in parallel to the feedback impedance element, and

a control circuit for putting the active circuit into an inactive state when the first measurement signal is supplied to the second terminal of the feedback impedance element, and putting the active circuit into an active state when the oscillation is performed.

3. A semiconductor integrated circuit device according to claim 2,

wherein the semiconductor integrated circuit device comprises a measurement circuit combined with the first and second terminals of the feedback impedance element, to output a digital value according to the delay time between the first measurement signal and the first observation signal.

4. A semiconductor integrated circuit device according to claim 3,

wherein the semiconductor integrated circuit device comprises an isolation circuit for electrically isolating between the first external terminal and the first terminal.

5. A semiconductor integrated circuit device according to claim 2,

wherein the semiconductor integrated circuit device comprises a second variable capacitance circuit which is coupled to the second terminal of the feedback impedance element and whose capacitance value is set by the configuration circuit,

wherein a second measurement signal is supplied to the first terminal of the feedback impedance element,

wherein, in response to the supply of the second measurement signal, a capacitance value of the second variable capacitance circuit is set by the configuration circuit based on the delay time with respect to the second measurement signal of a second observation signal generated at the second terminal of the feedback impedance element.

6. A semiconductor integrated circuit device according to claim 5,

wherein the first measurement signal is supplied to the first external terminal, and the second measurement signal is supplied to the second external terminal.

7. A semiconductor integrated circuit device mounted in a substrate, including a first external terminal combined with a first terminal of a crystal oscillator by a wiring pattern formed in the substrate, and a second external terminal combined with a second terminal of the crystal oscillator,

wherein the semiconductor integrated circuit device comprise:

a feedback resistive element including a first terminal combined with the first external terminal, and a second terminal combined with the second external terminal;

an amplitude circuit combined between the first terminal of the feedback resistive element and the second terminal of the feedback resistive element;

a first variable capacitance circuit combined with the first terminal of the feedback resistive element;

a second variable capacitance circuit combined with the second terminal of the feedback resistive element, and

a measurement circuit combined with the first terminal of the feedback resistive element as well as the second terminal of the feedback resistive element, to obtain the time difference between the change in a first signal at the first terminal of the feedback resistive element, and the change in a second signal at the second terminal of the feedback resistive element.

8. A semiconductor integrated circuit device according to claim 7,

wherein when a measurement signal is supplied to the first terminal of the feedback resistive element, the measurement circuit measures the delay time of the change in the second signal with respect to the change in the first signal,

wherein when a measurement signal is supplied to the second terminal of the feedback resistive element, the measurement circuit measures the delay time of the change in the first signal with respect to the change in the second signal.

9. A semiconductor integrated circuit device according to claim 8,
wherein each of the first and second variable capacitance circuits includes a plurality of capacitance elements,
wherein the semiconductor integrated circuit device includes a configuration circuit for selecting a capacitance element from the capacitance elements in each of the first and second variable capacitance circuits according to a setting signal, and combining the selected capacitance element with the first terminal of the feedback resistive element and with the second terminal of the feedback resistive element.

10. A semiconductor integrated circuit device according to claim 9,
wherein the semiconductor integrated circuit device comprises:

a measurement signal generating circuit for forming the measurement signal; and
a switch circuit combined between the first and second terminals of the feedback resistive element and the first and second external terminals, respectively, to electrically isolate between the first and second terminals of the feedback resistive element and the first and second external terminals, respectively, when the measurement signal generating circuit forms the measurement signal,
wherein the measurement circuit measures the capacitance value of each of the first variable capacitance circuit and the second variable capacitance circuit as the delay time.

11. A manufacturing method of an electronic device,
wherein the electronic device comprises:

a crystal oscillator whose a first and second terminals are combined with a wiring pattern formed in a board; and
a semiconductor integrated circuit device whose first and second external terminals are combined with the wiring pattern,
wherein the semiconductor integrated circuit device includes:

a feedback impedance element including a first terminal coupled to the first external terminal as well as a second terminal coupled to the second external terminal when the oscillation is performed using the crystal oscillator;
a first variable capacitance circuit coupled to the first terminal of the feedback impedance element; and
a configuration circuit for setting a capacitance value of the first variable capacitance circuit,

wherein the manufacturing method includes the steps of:

supplying a first measurement signal to the second terminal of the feedback impedance element, and
in response to the supply of the first measurement signal, setting a capacitance value of the first variable capacitance circuit by the configuration circuit so that the delay time of the signal generated at the first terminal of the feedback impedance element becomes a predetermined time.

12. A manufacturing method of an electronic device according to claim 11,
wherein the semiconductor integrated circuit device comprises a second variable capacitance circuit which is coupled to the second terminal of the feedback impedance element and whose capacitance value is set by the configuration circuit,
wherein the manufacturing method incudes the steps of:

supplying a second measurement signal to the first terminal of the feedback impedance element, and
in response to the supply of the second measurement signal, setting a capacitance value of the second variable capacitance circuit by the configuration circuit so that the delay time of the signal generated at the second terminal of the feedback impedance element becomes a predetermined value.

13. A manufacturing method of an electronic device according to claim 12,
wherein the semiconductor integrated circuit device comprises:

an active circuit coupled in parallel to the feedback impedance element, and
a control circuit for putting the active circuit into an inactive state when the first measurement single is supplied to the second terminal of the feedback impedance element and when the second measurement signal is supplied to the first terminal of the feedback impedance element, and for putting the active circuit into an active state when the oscillation is performed.

**14.** A manufacturing method of an electronic device according to claim 13,
wherein the semiconductor integrated circuit device comprises a measurement circuit combined with the first and second terminals of the feedback impedance element, to output a digital value according to the delay time between the signal at the first terminal of the feedback impedance element and the signal at the second terminal of the feedback impedance element,
wherein the manufacturing method includes the step of setting a capacitance value of each of the first variable capacitance circuit and the second variable capacitance circuit by the configuration circuit so that the digital value output from the measurement circuit becomes a predetermined value.

**15.** A manufacturing method of an electronic device according to claim 14,
wherein the semiconductor integrated circuit device comprises a nonvolatile memory storing a capacitance value that can be set in each of the first variable capacitance circuit and the second variable capacitance circuit, as well as the delay time corresponding to the capacitance value.

# FIG. 1

# FIG. 2

# FIG. 3

# FIG. 4

## FIG. 5

(A)

VOLTAGE

X1

X1

(B)

X2

CT1

VT

CT2

X2

(C)

Vck

OUTPUT

Δt

t0

t1

t2

TIME

FIG. 6

# FIG. 7

## FIG. 8

# FIG. 9

## FIG. 10

## FIG. 11

*FIG. 12*

EP 2 958 231 A1

# FIG. 13

EP 2 958 231 A1

# FIG. 14

# FIG. 15

OSCILLATOR CIRCUIT

EP 2 958 231 A1

FIG. 16

EP 2 958 231 A1

## FIG. 17

(A) ──────┐ ┆ D0=1
          └─────────── ┆
(B) ────→┌─── ┆ D1=1
         └── ┆
(C) ──────→┌── ┆ D2=1
           └─ ┆
(D) ────────→┌─ ┆ D3=0
             └ ┆
(E) ──────────→┌─ D4=0
               └
(F) ──────────↑────

         t0  t1

## FIG. 18

## FIG. 19A

## FIG. 19B

| CAPACITANCE VALUE | 0pF | 2pF | 4pF | 6pF | 10pF |
|---|---|---|---|---|---|
| DELAY TIME | 2us | 4us | 6us | 8us | 10us |

ADOPTED

# FIG. 20A

# FIG. 20B

| CAPACITANCE VALUE | 0pF | 2pF | 4pF | 6pF | 10pF |
|---|---|---|---|---|---|
| DELAY TIME (T2) | 2us | 4us | 6us | 8us | 10us |
| DELAY TIME COMPARISON T1>T2 | ○ | ○ | × | × | × |

ADOPTED

Europäisches
Patentamt

European
Patent Office

Office européen
des brevets

## EUROPEAN SEARCH REPORT

Application Number

EP 15 17 2057

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/126907 A1 (NAKAMOTO HIROYUKI [JP] ET AL) 24 May 2012 (2012-05-24) * paragraph [0046] - paragraph [0058]; figures 3,4,12 * | 1-15 | INV. H03B5/36 G01R31/28 |
| X | JP H07 131247 A (NIPPON PRECISION CIRCUITS) 19 May 1995 (1995-05-19) * figures 1,4 * | 1 | |
| A | US 2009/261914 A1 (KAO HUEH-WU [TW] ET AL) 22 October 2009 (2009-10-22) * figure 2A * | 1-15 | |

TECHNICAL FIELDS
SEARCHED (IPC)

H03B
G01R

The present search report has been drawn up for all claims

| Place of search | Date of completion of the search | Examiner |
|---|---|---|
| Munich | 8 October 2015 | Schnabel, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 15 17 2057

This annex lists the patent family members relating to the patent documents cited in the above-mentioned European search report.
The members are as contained in the European Patent Office EDP file on
The European Patent Office is in no way liable for these particulars which are merely given for the purpose of information.

08-10-2015

| Patent document cited in search report | | Publication date | Patent family member(s) | | Publication date |
|---|---|---|---|---|---|
| US 2012126907 | A1 | 24-05-2012 | JP<br>JP<br>US | 5570954 B2<br>2012114651 A<br>2012126907 A1 | 13-08-2014<br>14-06-2012<br>24-05-2012 |
| JP H07131247 | A | 19-05-1995 | JP<br>JP | 3288830 B2<br>H07131247 A | 04-06-2002<br>19-05-1995 |
| US 2009261914 | A1 | 22-10-2009 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014123581 A
- JP 2000134036 A
- JP 2003283249 A